# EUROPÄISCHE PATENTSCHRIFT

(11) **EP 2 752 504 B1**
(45) Veröffentlichungstag und Bekanntmachung des Hinweises auf die Patenterteilung: **06.04.2016**
(21) Anmeldenummer: 13000063.1
(22) Anmeldetag: 08.01.2013
(51) Int. Cl.: C23C 22/83, C23C 22/60, C23C 22/80, C23C 22/74, C23C 22/76, C23C 22/66, C23C 14/58, C23C 28/00, C09D 5/00, C09D 5/08, C09D 5/12, B05D 7/14, B05D 7/16

(54) **Verfahren zur Herstellung eines korrosionsgeschützten, glänzenden, metallisch beschichteten Substrats, das metallisch beschichtete Substrat sowie dessen Verwendung**
Method for producing a corrosion resistant, glossy, metallic coated substrate, the metallic coated substrate, and its use
Procédé de fabrication d'un substrat à revêtement métallique, résistant à la corrosion, brillant, le substrat à revêtement métallique, et son utilisation

(43) Veröffentlichungstag der Anmeldung: 09.07.2014
(73) Patentinhaber: ROPAL Europe AG, 35099 Burgwald (DE)
(72) Erfinder: Braun, Willi, 35108 Allendorf/Eder (DE); Dornseif, Matthias, 35066 Frankenberg (DE)
(74) Vertreter: Metten, Karl-Heinz

(56) Entgegenhaltungen:
- EP-A1- 0 678 596
- EP-A1- 1 870 489
- DE-A1- 10 210 269
- DE-A1-102007 046 925

## Beschreibung

Die Erfindung betrifft ein Verfahren zur Herstellung eines, insbesondere korrosionsgeschützten und/oder glänzenden, metallischen oder nicht-metallischen metallisch beschichteten Substrats sowie ein, insbesondere korrosionsgeschütztes und/oder glänzendes, metallisches oder nicht-metallisches metallisch beschichtetes Substrat sowie dessen Verwendung.

Die optische Veredelung beliebiger Substrate, bei der diesen Substraten ein metallisches Erscheinungsbild gegeben wird, ist seit langem bekannt. Wesentliche Anforderungen an metallische Substrate wie auch an metallisch beschichtete Substrate sind eine ausgezeichnete Korrosionsbeständigkeit und eine ansprechende Optik. Hierbei wird häufig die Anmutung verchromter Substrate angestrebt. Von besonderer Bedeutung sind Substrate mit metallisch glänzendem und korrosionsbeständigem Eigenschaftsprofil auch in der Automobilindustrie, beispielsweise bei der Herstellung von Rädern bzw. Felgen, insbesondere Leichtmetallrädern bzw. Leichtmetallfelgen. Von derartigen Produkten erwartet man ein chromglänzendes Erscheinungsbild, das widerstandsfähig gegenüber gängigen Nutzungsbedingungen ist.

Aus dem Stand der Technik ist beispielsweise ein Verfahren zur Erzeugung einer hochglänzenden Oberfläche bekannt, mit dem Leichtmetallfelgen galvanisch verchromt werden. Bei diesem Verfahren wird eine nur wenige tausendstel Millimeter dicke Chromschicht auf eine Leichtmetallfelge aufgetragen. Um nicht sämtliche Unebenheiten der Substratoberfläche abzubilden, müssen die Felgen vor der galvanischen Beschichtung geschliffen, hochglanzpoliert und gründlich vorbereitet werden. Ansonsten würde man sämtliche Poren, Kratzer und Unebenheiten nach dem Verchromungsschritt deutlich auf der beschichteten Felge erkennen. Die Verfahrensschritte des Schleifens und Hochglanzpolierens sind selbst bei wenig anspruchsvoller Substratgeometrie sehr zeit- und arbeitsintensiv. Zudem ist der galvanische Prozess als solcher arbeitssicherheitstechnisch aufwendig und kann bei unsachgemäßer Handhabung die Umwelt gefährden. Auch kommt es nicht selten zur bekannten Kontaktkorrosion, sobald die galvanisch aufgetragene Chromoberfläche verletzt wird. Unter Einwirkung von z.B. Regenwasser oder Schneeschmelzwasser, das in der Regel gelöstes Streusalz enthält, entsteht eine elektrische Spannungsreihe zwischen dem edleren Teil (in diesem Fall Chrom als Deckschicht) und dem unedleren Metall des Substrats (beispielsweise einer Aluminium- bzw. Magnesiumlegierung oder Edelstahl). Dabei löst sich das unedlere Metall auf. Folglich kann z.B. eine Felge im ungünstigsten Fall bei Korrosion erheblich geschädigt werden, was sich in der Folge kritisch sowohl auf das optische Erscheinungsbild als auch auf die Festigkeitswerte der Felge bei dynamischer Beanspruchung während des Einsatzes auswirkt. Von Nachteil bei der galvanischen Verchromung ist ferner, dass die galvanisch aufgebrachte Chromschicht häufig einen anderen Dehnungskoeffizienten aufweist als das darunter liegende Substratmaterial. Schon allein hierdurch können Spannungen auftreten, die zu Rissen oder sogar Abplatzungen führen. Derartige Schäden lassen sich in der Regel nicht punktuell beheben bzw. maskieren.

Aus dem Stand der Technik sind auch solche Beschichtungsverfahren bekannt, bei denen Chrom durch Kathodenzerstäubung (Sputtern) im Hochvakuum auf einem Substrat abgeschieden wird. Das Verfahren wird unter hoher elektrischer Spannung betrieben. Ein derart nach dem Sputterverfahren beschichtetes Substrat kommt einem galvanisch verchromten Substrat nicht ansatzweise nahe, sondern mutet eher wie Schwarzchrom an und ist demzufolge mit einer dunkleren Oberfläche ausgestattet. Sogenannte Schwarzchrom-Oberflächen sind z.B. auch für sämtliche glänzenden Sanitärartikel unakzeptabel. Ferner erfüllt ein Metallsubstrat, z.B. eine Leichtmetallfelge, die durch ein Sputter-Chrombeschichtungsverfahren hergestellt worden ist, regelmäßig nicht die Testanforderungen, die als Mindeststandard von der Automobilindustrie vorgeschrieben werden, wie beispielsweise die Gitterschnittprüfung nach DIN EN ISO 2409, den Salzsprühtest (Kupferchlorid/Essigsäure) nach DIN 50021-CASS(240h), die Kondenswasserkonstantklimaprüfung nach DIN 50017 KK und die Chemikalienbeständigkeitsprüfung nach VDA 621-412.

Aus der DE 102 10 269 A1 ist ein Verfahren zur haftfesten Beschichtung eines Substrats bekannt, mit dem ein metallisches Aussehen verliehen werden soll. Hierbei wird zunächst auf das Substrat eine Grundierungsschicht aufgebracht und getrocknet. Die Grundierungsschicht wird dann mit einem anorganischen Haftvermittler behandelt. Anschließend wird eine Silberschicht aufgetragen. Schließlich werden die aufgebrachten Schichten mit einem Schutzlack überzogen. Bei nach diesem Verfahren beschichteten Substraten findet verhältnismäßig schnell eine Oxidation der Silberschicht durch den nicht vollständig abdichtenden Schutzlack hindurch statt. Dieses führt zu einer Enthaftung der Silberschicht von dem Substrat und schließlich zu einer gelblichen Verfärbung.

Zur Erzielung eines hinreichenden Korrosionsschutzes von Metallteilen werden häufig chromathaltige Beschichtungen, auch Konversionsschichten genannt, aufgebracht. Aufgrund der hellgelb irisierenden Wirkung derartiger Beschichtungen spricht man auch vom Gelbchromatieren. Anders als anodisch aufgebrachte Schutzbeschichtungen bieten Chromat-Konversionsschichten regelmäßig keinen Schutz mehr, sobald die Oberfläche verkratzt wird. Chromatierte Oberflächen können durch Tauchverfahren oder Spritz-/Sprühverfahren erhalten werden. Exemplarisch sei für die Aufbringung von Chromatschutzschichten auf die US 2,825,697 und die US 2,928,763 verwiesen. Die Applizierung einer konventionellen Konversionsschicht auf Chromatbasis ist unter anderem auch der WO 2004/014646 A1 zu entnehmen.

Eine modifizierte Chromatbeschichtung geht aus der WO 01/51681 A2 hervor, wonach eine geeignete Passivierungslösung Chrom-(III)chlorid und Natriumnitrat zu enthalten hat.

In der DE 197 02 566 C2 ist das Verfahren zur Glanzbeschichtung von Fahrzeugteilen mit Hilfe einer Chromatschicht dahingehend modifiziert worden, dass man auf einer auf der Chromatschicht vorliegenden Pulverlackschicht eine Hochglanzschicht aus einem Metall mit Hilfe eines Magnetrons im Vakuum aufbringt. Hierdurch lassen sich, ohne dass es der Zugabe externer Pigmente bedarf, gezielt Farbeffekte einstellen.

Des weiteren ist aus der WO 01/51681 A2 und der DE 602 00 458 T2 bekannt, dass Metallschichten nicht nur durch Behandeln mit einer Passivierungs- bzw. Konversionslösung enthaltend Chromat korrosionsbeständig gemacht werden können, sondern dass hierfür ebenfalls schwerlösliche Metallphosphatüberzüge, beispielsweise auf Zink- oder Eisenphosphatbasis, eingesetzt werden können.

Zur chromfreien Oberflächenbehandlung kann gemäß der DE 103 32 744 A1 auch auf ein wässriges Gemisch enthaltend ein zumindest teilweise hydrolysiertes fluorfreies Silan und ein zumindest teilweise hydrolysiertes fluorhaltiges Silan zurückgegriffen werden.

Nach der DE 602 00 458 T2 lässt sich eine hinreichende Korrosionsbeständigkeit dadurch erzielen, dass der Korrosionsschutzanstrich ein metallisches Zinkpulver und mindestens einen Metallsalzrostinhibitor enthält, wobei dieses Metallsalz auf Magnesium, Aluminium, Calcium und Barium zurückgeht und über eine durchschnittliche Durchmessergröße von nicht mehr als 1 µm verfügt. Das Metall des Metallsalzes hat basischer als Zink zu sein.

Ein guter Korrosionsschutz stellt sich nach der DE 100 49 005 A1 dann ein, wenn die Verfahrensstufe der Behandlung mit einem Passivierungsmittel mit der der Aufbringung eines Gleitmittels zusammenfällt. Vorraussetzung hierfür ist, dass das das Gleitmittel enhaltende Mittel nicht im Wesentlichen aus Titan oder/und Zirkonium sowie Fluor und einem Polymer besteht. Dieser Ansatz macht Gebrauch von langkettigen Molekülresten, die, wie von oberflächenaktiven Substanzen, z.B. Tensiden, bekannt, zur Selbstanordnung neigen. Dementsprechend ist diese Technologie auch unter SAM-Beschichtung bekannt (Self Assembling Molecules).

Eine chromfreie Oberflächenbeschichtung von Metallen, die sich mit hohen Beschichtungsgeschwindigkeiten auftragen lässt, basiert gemäß der DE 101 49 148 A1 auf einer wässrigen Zusammensetzung, enthaltend einen organischen Filmbildner, der mindestens ein wasserlösliches oder wasserdispergiertes Polymer mit einer Säurezahl im Bereich von 5 bis 200, mindestens eine anorganische Verbindung in Partikelform mit einem mittleren Partikeldurchmesser im Bereich von 0,005 bis zu 0,3 µm und mindestens ein Gleitmittel enthält, wobei der aufgetragene getrocknete Film eine Schichtdicke im Bereich von 0,01 bis 10 µm, eine Pendelhärte von 50 bis 180 s und eine solche Flexibilität aufweist, dass beim Biegen über einem konischen Dorn nach DIN ISO 6860 keine Risse länger als 2 mm entstehen. Als organische Filmbildner kommen Kunstharze auf der Basis von Acrylaten, Butadienen, Ethylen, Polyester, Polyurethan, Siliconpolyestern, Epoxiden, Phenol, Styrol und Hamstoff-Formaldehyd in Betracht. Jedes der Dokumente EP 0 678 596 A1, DE 102007046925 A1 und EP 1 870 489 A1 beschreibt ein mehrstufiges Verfahren zur Herstellung eines korrosionsgeschützten und hochglänzenden metallisch beschichten Substrats. Die US 6,896,920 B2 offenbart eine mehrlagige Glanzbeschichtung, bei der zunächst auf eine metallische Substratoberfläche eine Polymerschicht aufzubringen ist. Anschließend ist diese Polymerbeschichtung mit einer Metallschicht zu versehen. Auf diese Metallschicht wird sodann eine korrosionshindernde anorganische Schicht aufgetragen. Die abschließende, oberste Schicht dieses mehrlagigen Systems stellt eine transparente Schutzlackschicht dar. Obwohl als korrosionshindernd ausgewiesen, wird bei den mehrschichtigen Substraten gemäß der US 6,896,920 B2 beim CASS-Salzsprühnebeltest bereits nach 168 Stunden eine korrosionsbedingte Veränderung der Oberfläche festgestellt. Die Automobilindustrie for-dert jedoch regelmäßig den Nachweis einer unveränderten Oberfläche auch noch nach 240 Stunden.

Aufgabe der vorliegenden Erfindung ist es, ein Verfahren zur Herstellung beschichteter Substrate, insbesondere von korrosionsgeschützten und/oder glänzenden beschichteten Substraten, sowie beschichtete Substrate, insbesondere korrosionsgeschützte und/oder glänzende beschichtete Substrate, bereitzustellen, das bzw. die nicht mehr mit den Nachteilen des Stands der Technik behaftet sind. Insbesondere liegt der Erfindung die Aufgabe zugrunde, ein Verfahren verfügbar zu machen, mit dem, insbesondere korrosionsgeschützte und/oder glänzende, beschichtete Substrate zugänglich sind, die bei mechanischer Beanspruchung oder Beschädigung über einen langen Zeitraum korrosionsbeständig sind und eine sehr ansprechende Optik zeigen bzw. behalten, wie sie herkömmlicher Weise allenfalls mittels galvanischer Verchromung erhalten wird. Ferner liegt der Erfindung die Aufgabe zugrunde, ein Verfahren zur Herstellung von, insbesondere korrosionsgeschützten und/oder glänzenden beschichteten Substraten zugänglich zu machen, das auf arbeitstechnisch einfache und zuverlässige Weise solche beschichteten Substrate liefert, die keine Ablaufspuren oder Schlieren mehr zeigen und die sich durch eine gute Haftung sämtlicher Schichten auszeichnet und insbesondere eine verbesserte Haftung der äußeren Schutz- bzw. Decklackschicht mit sich bringt. Schließlich lag der Erfindung die Aufgabe zugrunde, beschichtete Substrate, insbesondere korrosionsgeschützte und/oder glänzende beschichtete Substrate verfügbar zu machen, die sich durch eine geringe Kratzernpfindlichkeit auszeichnen.

Diese Aufgabe wird erfindungsgemäß gelöst durch ein Verfahren zur Herstellung eines, insbesondere korrosionsgeschützten und/oder glänzenden, metallischen oder nicht-metallischen metallisch beschichteten Substrats, umfassend die Schritte:
a) Zurverfügungstellung mindestens eines Substrats mit mindestens einer zumindest bereichsweise metallisch beschichtbaren Oberfläche;
c) Aufbringen mindestens einer metallischen Kompositschutzschicht, enthaltend als Hauptkomponente mindestens ein erstes Metall ausgewählt aus der Gruppe, bestehend aus Aluminium, Mangan, Magnesium und Zink, oder mindestens eine erste Metalllegierung ausgewählt aus der Gruppe, bestehend aus Stahl, Edelstahl, einer Magnesiumlegierung und einer Aluminiumlegierung, und in der Hauptkomponente verteilt vorliegend als Minderkomponente mindestens ein zweites Metall und/oder mindestens ein oxydisch gebundenes zweites Metall, ausgewählt aus der Gruppe, bestehend aus Zirkonium, Titan und Hafnium, oder bestehend aus der Hauptkomponente und der Minderkomponente, wobei der Verfahrensschritt c) die Teilschritte umfasst
   i) Aufbringen mindestens einer Metallschicht enthaltend das oder bestehend aus dem mindestens einen ersten Metall oder enthaltend die oder bestehend aus der mindestens einen ersten Metalllegierung mittels Aufdampf- und/oder Sputter-Technik auf der beschichtbaren Oberfläche des Substrats und
   ii) Behandeln der Metallschicht gemäß Schritt i) mit mindestens einem, insbesondere sauren, ersten wässrigen System, enthaltend mindestens eine erste Verbindung des zweiten Metalls,
   so dass vorzugsweise die mindestens eine erste Verbindung des zweiten Metalls und/oder mindestens eine zweite Verbindung des zweiten Metalls, die aus der mindestens einen ersten Verbindung während dieses Behandlungsschritts, insbesondere bei Kontakt mit der Metallschicht und/oder bei Migration in die Metallschicht, hervorgeht, und/oder das zweite Metall, das aus der mindestens einen ersten und/oder zweiten Verbindung während dieses Behandlungsschritts, insbesondere bei Kontakt mit der Metallschicht und/oder bei Migration in die Metallschicht, hervorgeht, in die Metallschicht unter Ausbildung der Kompositschutzschicht eingetragen wird bzw. werden und in der Kompositschutzschicht insbesondere als Metall und/oder oxydisch gebunden vorliegt bzw. vorliegen;
d) Silanisieren der Kompositschutzschicht aus Schritt c) ii) durch Behandeln mit mindestens einem, insbesondere alkalischen, zweiten wässrigen System unter Ausbildung mindestens einer Polysiloxanschicht, insbesondere unmittelbar auf der Kompositschutzschicht; und
e) Aufbringen mindestens einer Lackschicht, insbesondere unmittelbar, auf der Polysiloxanschicht gemäß Schritt d).

In der metallischen Kompositschutzschicht liegt mindestens ein zweites Metall und/oder mindestens ein oxydisch gebundenes zweites Metall verteilt bzw. einbettet in dem die ersten Hauptkomponente darstellenden ersten Metall oder der ersten Metalllegierung vor. In einer Ausführungsform liegen das zweite Metall und/oder das oxydisch gebundene zweite Metall im Wesentlichen gleichmäßig verteilt in dem ersten Metall oder der ersten Metalllegierung vor. In einer weiteren Ausführungsform finden sich mindestens ein zweites Metall und/oder mindestens ein oxydisch gebundenes zweites Metall im Wesentlichen, insbesondere gleichförmig, über die gesamte Dicke der Kompositschutzschicht in dem ersten Metall oder der ersten Metalllegierung verteilt. Die metallische Kompositschutzschicht kann demgemäß auch als eine innige Vermengung, enthaltend ein erstes Metall oder eine erste Metalllegierung und darin vorliegend bzw. eingebettet mindestens ein zweites Metall und/oder mindestens ein oxydisch gebundenes zweites Metall verstanden werden.

Mit dem erfindungsgemäßen Verfahren wird ein metallisch beschichtetes Substrat mit einer metallischen Kompositschutzschicht erhalten, die als solche selber hoch korrosionsgeschützt ist und zudem durch Aufbringung auf ein Substrat auch dieses Substrat, sofern es sich um ein metallisches Substrat handelt, vor Korrosion schützt. Während bei nicht-metallischen Substraten die Eigenschaft des Korrosionsschutzes sich somit auf die metallische Schutzschicht bezieht, wird bei metallischen Substraten nicht nur eine selber korrosionsgeschützte metallische Schutzschicht erhalten, vielmehr stattet diese Kompositschutzschicht das metallische Substrat mit einem sehr wirksamen Korrosionsschutz aus, insbesondere auch dann, wenn das Metall des metallischen Substrats und das erste Metall der Kompositschutzschicht übereinstimmen. Gleichzeitig ist diese metallische Kompositschutzschicht in der Regel hochglänzend, so dass hochglänzende, sehr beständige Substratoberflächen zugänglich werden. Unter korrosionsgeschützt im Sinne der vorliegenden Erfindung soll verstanden werden, dass die beschichteten Substrate ein hohes Maß an Korrosionsschutz liefern und Korrosion unter den üblichen Nutzungsbedingungen verhindern bzw. vermindern helfen. Mit der Verwendung des Begriffs korrosionsgeschützt wird nicht der Anspruch erhoben, stets ein unter allen erdenklichen Bedingungen absolut korrosionsbeständiges beschichtetes Substrat zu erhalten. Vielmehr geht es darum, einen unter regulären Nutzungsbedingungen verbesserten, langlebigeren Korrosionsschutz zu ermöglichen, so dann gegebenenfalls auch neue Anwendungen eröffnet werden.

Geeignete Substrate können sowohl metallischer als auch nicht-metallischer Natur sein. Als geeignete nicht-metallische Substrate kommen z.B. solche enthaltend bzw. aus Glas, Karbonmaterialien, Keramik oder Kunststoff in Betracht. Besonders geeignete Kunststoffe stellen PVC, Polyolefine, insbesondere Polypropylen, Polyamide, Polyester, Polycarbonate und Polyoxyalkylene, z.B. POM, dar. In geeigneten Substraten können neben metallischen Komponenten oder Abschnitten auch nicht-metallische Komponenten bzw. Abschnitte vorliegen. Als metallische Substrate sind z.B. Magnesium, Titan oder Aluminium oder Metalllegierungen, insbesondere Magnesium-, Titan- oder Aluminiumlegierungen, oder Edelstahl geeignet. Grundsätzlich eigenen sich als metallische Substrate Formkörper aus allen Metallen, Metalllegierungen und Edelmetallen. Als geeignete Substrate seien exemplarisch solche aus Aluminium, Eisen, Stahl, Edelstahl, Kupfer, Messing, Magnesium, Iridium, Gold, Silber, Palladium, Platin, Ruthenium, Molybdän, Nickel, Bronze, Titan, Zink, Blei, Wolfram oder Mangan sowie deren Legierungen genannt. Bevorzugte Metallsubstrate bzw. Metallsubstratoberflächen umfassen bzw. insbesondere bestehen aus Aluminium oder Aluminiumlegierungen, Magnesium oder Magnesiumlegierungen oder Titan oder Titanlegierungen oder Eisen oder Eisenlegierungen. Bevorzugt wird hierbei hochreines Aluminium, Magnesium oder Titan, insbesondere mit einem Aluminium-, Magnesium- bzw. Titananteil von mindestens 90 Gew.-%, insbesondere mindestens 99 Gew.-%, bezogen auf das Gesamtgewicht der metallischen Schutzschicht, eingesetzt. Besonders bevorzugt wird für die metallischen Substrate auf Aluminium und Aluminiumlegierungen zurückgegriffen.

Die durchschnittliche Dicke der gemäß Verfahrensschritt c) des erfindungsgemäßen Verfahrens auf das Substrat aufzubringenden metallischen Schutz- bzw. Kompositschutzschicht oder der Metallschicht gemäß Schritt c)i) liegt üblicherweise im Bereich von 5 nm bis 500 nm, vorzugsweise im Bereich von 10 nm bis 300 nm und besonders bevorzugt im Bereich von 20 nm bis 200 nm. In besonders zweckmäßigen Ausgestaltungen liegt diese Dicke im Bereich von 50 nm bis 150 nm. Wählt man zu geringe Dicken, besteht die Gefahr, transluzente Schichten zu erhalten. Bei zu ausgeprägten Schichtdicken können sich zuweilen je nach Anwendungsfall Haftungsprobleme ergeben.

Sehr zufriedenstellende Resultate werden beispielsweise mit Schichtdicken im Bereich von 50 nm bis 120 nm erzielt. Die erfindungsgemäßen Resultate stellen sich regelmäßig bereits mit durchschnittlichen Schichtdicken kleiner 100 nm ein.

Erfindungsgemäß umfasst das erste Metall für die metallische Schutz- bzw. Kompositschutzschicht gemäß Schritt c) bzw. die Metallschicht gemäß Schritt c)i) insbesondere Aluminium, Magnesium oder Titan bzw. die erste Metalllegierung Stahl, Edelstahl oder eine Aluminium-, Titan- oder Magnesiumlegierung. Eine besonders geeignete Kompositschutzschicht umfasst Aluminium oder eine Aluminiumlegierung.

Insbesondere bevorzugt ist, dass die Reinheit des ersten Metalls, vorzugsweise des Aluminiums, mindestens 80 Gew.-%, vorzugsweise mehr als 90 Gew.-%, am besten mindestens 99 Gew.-%, beträgt.

Dabei kann in einer bevorzugten Ausgestaltung vorgesehen sein, dass das erste Metall Aluminium, Magnesium und Titan, oder dass die erste Metalllegierung ausgewählt ist aus der Gruppe, bestehend aus Stahl, Edelstahl, mindestens einer Magnesium-, mindestens einer Titan- und mindestens einer Aluminiumlegierung und/oder dass das zweite Metall ausgewählt ist aus der Gruppe, bestehend aus Zirkonium und Titan. Eine weitere bevorzugte Ausführungsform sieht vor, dass die erste Verbindung des zweiten Metalls mindestens ein Oxid, Doppeloxid, Oxid-Hydrat, Oxyhalogenid, Halogenid, Salz und/oder eine Säure, insbesondere eine Säure, umfasst. Dabei stellt die zweite Verbindung des zweiten Metalls vorzugsweise ein oxydisch gebundenes zweites Metall darstellt, insbesondere ein Oxid, Doppeloxid, Oxid-Hydrat und/oder Oxyhalogenid.

Bevorzugt wird für das zweite Metall auf Zirkonium bzw. auf Verbindungen des Zirkoniums zurückgegriffen. Selbstverständlich können auch beliebige Mischungen von Verbindungen des zweiten Metalls für die Herstellung der Kompositschutzschicht verwendet werden. Demgemäß können auch beliebige Mischungen von zweiten Metallen und/oder von oxydisch gebundenen zweiten Metallen nebeneinander in der metallischen Kompositschutzschicht vorliegen. Ersichtlich ist das erfindungsgemäße Verfahren technisch weit von einer herkömmlichen galvanischen Verchromung entfernt, gleichwohl lassen sich hinsichtlich Glanzeffekt, Glanzbeständigkeit und Korrosionsbeständigkeit mindestens ebenbürtige Ergebnisse erzielen.

In der Kompositschutzschicht liegt das zweite Metall bzw. das oxydisch gebundene zweite Metall, vorzugsweise Zirkonium, in Mengen von 0,2 bis 10 Gew.-%, vorzugsweise im Bereich von 1 bis 7 Gew.-% und besonders bevorzugt im Bereich von 1,5 bis 5 Gew.-%, bezogen auf das Gesamtgewicht der metallischen Kompositschutzschicht, in dieser Kompositschutzschicht vor.

Oxydisch gebundene zweite Metalle umfassen z.B. auch Doppeloxide wie Aluminium/Zirkoniumoxide.

Ohne an irgendeine Theorie gebunden zu sein, wird gegenwärtig angenommen, dass die Verbindungen des zweiten Metalls, die in dem wässrigen System z.B. als Säure oder Salz vorliegen, in der metallischen Kompositschutzschicht in oxydisch gebundenes zweites Metall bzw. in dieses zweite Metall überführt vorliegen.

Geeignete Säuren der zweiten Metalle umfassen z.B. Hydrofluorzirkonsäure (H₂ZrF₆), Fluortitansäure (H₂TiF₆) und Fluorhafniumsäure (H₂HfF₆). Selbstverständlich können auch Mischungen unterschiedlicher Säuren eingesetzt werden. Diese Fluorsäuren können sowohl im Reinzustand als auch enthaltend Verunreinigungen, beispielsweise Fluorsäure, eingesetzt werden. In den wässrigen Systemen können die Säuren z.B. in Mengen von bis zu 5 Gew.-%, insbesondere von bis zu 3,5 Gew.-%, bezogen auf das Gesamtgewicht des wässrigen Systems, vorliegen. Fluorsäure kann in den wässrigen Systemen, z.B. in Mengen im Bereich von 0,1 bis 3 Gew.-%, ebenfalls zugegen sein.

Unter den geeigneten Salzen wird bevorzugt auf Ammoniumzirkoniumcarbonat, das beispielsweise von der Firma Magnesium Electron Inc. unter der Markenbezeichnung Bacote 20 erhältlich ist, zurückgegriffen ((NH₄)₂[Zr(OH)₂(CO₃)₂]·n H₂O). Ferner können auch Alkalimetall- und Ammoniumfluorzirkonate, beispielsweise Na₂ZrF₆, KZrF₆, (NH₄)ZrF₆, ebenso wie Zirkoniumnitrate, Zirkoniumoxynitrate, Zirkoniumcarbonate, Zirkoniumfluoride oder Zirkoniumsulfat eingesetzt werden. Diese Verbindungen von zweiten Metallen können als solche oder in beliebiger Mischung miteinander eingesetzt werden.

Dabei kann in einer Ausgestaltung vorgesehen sein, dass die Oxide des zweiten Metalls Zirkoniumoxide, Titanoxide und/oder Hafniumoxide, die Oxyhalogenide des zweiten Metalls Zirkoniumoxyhalogenide, insbesondere -fluoride, Titanoxyhalogenide, insbesondere - fluoride, und/oder Hafniumoxyhalogenide, - insbesondere -fluoride, die Säuren des zweiten Metalls Fluorzirkonsäure, Fluortitansäure und/oder Fluorhafniumsäure und/oder die Salze des zweiten Metalls Fluorzirkonate, Fluortitanate und/oder Fluorhafniate darstellen.

Gemäß einer weiteren Ausführungsform des erfindungsgemäßen Verfahrens ist vorgesehen, dass die Aufdampf- bzw. Sputter-Technik in Schritt c) ) Physical Vapor Deposition (PVD), Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere jeweils in einem Hochvakuum durchgeführt, umfasst.

Für die Aufbringung der Metallschicht gemäß Schritt c)i) ) kann als geeignete Aufdampf- bzw. Sputtertechnik z.B. auf das Verfahren der Physical Vapor Deposition (PVD)-Beschichtung, das Aufdampfen mittels eines Elektronenstrahl-Verdampfers, das Aufdampfen mittels eines Widerstandsverdampfers, die Induktionsverdampfung, die ARC-Verdampfung und die Kathodenzerstäubung (Sputter-Beschichtung), jeweils vorzugweise in einem Hochvakuum, zurückgegriffen werden. Diese Verfahren sind dem Fachmann bekannt. Die metallische Schutz- bzw. Kompsitschicht oder die Metallschicht können beispielsweise auf dem Substrat bzw. auf dessen beschichtbarer Oberfläche, der ersten Grundierungsschicht, der zweiten Grundierungsschicht und/oder dem Haftvermittler aufgebracht werden. Bevorzugt wird ein Physical Vapor Deposition-Beschichtungsverfahren (PVD) eingesetzt. Dabei kommen widerstandsbeheizte Metallwendel- oder Metallschiffchenverdampfer zum Einsatz, wobei Wolframwendeln der verschiedensten Form bevorzugt sind. Beim PVD-Verfahren wird im Allgemeinen ein Verdampfer mit Wendeln bestückt, die auf voneinander isolierten Verdampferschienen geklemmt werden können. In jede Wendel wird vorzugsweise eine genau bestimmte Menge an erstem Metall oder erster Metalllegierung gegeben. Nach dem Schließen und Evakuieren der PVD-Anlage kann die Verdampfung durch Einschalten der Stromversorgung, wodurch man die Verdampferschienen die Wendel zum Glühen gebracht, gestartet werden Das feste Metall beginnt zu schmelzen und benetzt die meist verdrillten Wendeln vollständig. Durch weitere Energiezufuhr wird das flüssige Metall in die Gasphase überführt, so dass es sich auf dem zu beschichtenden Substrat abscheiden kann.

Die Verdampfung aus Metallschiffchen läuft in ähnlicher Weise ab. Die Verdampferausrüstung ist dabei prinzipiell identisch, jedoch werden Schiffchen meist aus hochschmelzenden Metallblechen eingesetzt, wie Wolfram-, Tantal- oder Molybdän-Schiffchen.

Ein weiteres bevorzugtes Verfahren zur Abscheidung der Metallschicht auf dem Substrat ist die Kathodenzerstäubung (Sputter-Verfahren). Dabei wird in einem evakuierten Behälter eine Kathode angeordnet, die mit dem negativen Pol einer Stromversorgung verbunden ist. Das Beschichtungsmaterial, das zerstäubt wird, wird unmittelbar vor der Kathode montiert und die zu beschichtenden Substrate werden gegenüber dem zu zerstäubenden Beschichtungsmaterial angeordnet. Ferner kann Argon als Prozessgas durch den Behälter geleitet werden, der schließlich noch eine Anode aufweist, die mit dem positiven Pol einer Stromversorgung verbunden ist. Nachdem der Behälter vorevakuiert worden ist, werden Kathode und Anode mit der Stromversorgung verbunden. Durch den gezielten und gesteuerten Einlaß von Argon wird die mittlere freie Weglänge der Ladungsträger deutlich gesenkt. Im elektrischen Feld zwischen Kathode und Anode werden Argonatome ionisiert. Die positiv geladenen Teilchen werden mit hoher Energie zur negativ geladenen Kathode beschleunigt. Beim Auftreffen und durch Teilchenstöße im Beschichtungsmaterial wird dieses in die Dampfphase überführt, mit hoher Energie in den freien Raum beschleunigt und kondensiert dann auf den zu beschichtenden Substraten.

Weitere in dem erfindungsgemäßen Verfahren einsetzbare Aufdampfverfahren erfolgen unter Einsatz einer Elektrodenstrahl-Verdampfung, Widerstandsverdampfung, Induktionsverdampfung und/oder einer Verdampfung mit Hilfe eines thermischen, nichtstationären Bogens (ARC-Verdampfung).

Im Übrigen sind Verfahren zur Aufbringung einer Metallschicht auf ein metallisches oder nicht-metallisches Substrat dem Fachmann bekannt und sollen vorliegend, auch wenn nicht ausdrücklich genannt, mit umfasst sein.

Gemäß einer Weiterentwicklung umfasst das erfindungsgemäße Verfahren in einer bevorzugten Ausführungsform ferner zwischen den Schritten a) und c) ) den Schritt:
b) ) Aufbringen zumindest einer ersten und gegebenenfalls einer zweiten Grundierungsschicht auf das, insbesondere metallische oder Kunststoff-, Substrat und/oder Schleifen und/oder Polieren der, insbesondere metallischen, Substratoberfläche.

Als besonders geeignet hat sich für metallische Substrate ein Verfahren erwiesen, umfassend nach Schritt a) die folgenden Schritte:
b) Aufbringen zumindest einer ersten Grundierungsschicht auf das Substrat und/oder Schleifen und/oder Polieren der Substratoberfläche,
c)i) Aufbringen einer Metallschicht, umfassend mindestens ein erstes Metall und/oder mindestens eine erste Metalllegierung, auf die erste Grundierungsschicht und/oder auf die polierte und/oder geschliffene Substratoberfläche mittels Physical Vapor Deposition (PVD)-Beschichtung, Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung), insbesondere im Vakuum, und
c)ii) Behandeln der Metallschicht mit dem ersten wässrigen System, enthaltend mindestens eine eine Säure und/oder ein Salz eines zweiten Metalls, unter Ausbildung der metallischen Kompositschutzschicht.

Dabei kann vorgesehen sein, dass mindestens eine zweite Grundierungsschicht auf die erste Grundierungsschicht aufgebracht wird.

Hierbei ist es häufig von Vorteil, dass die erste und/oder zweite Grundierungsschicht nach dem Aufbringen in zumindest einem anschließenden Wärmebehandlungsschritt ausgehärtet und/oder eingebrannt werden.

Alternativ zur Aufbringung einer ersten und gegebenenfalls zweiten Grundierungsschicht oder zusätzlich zu der Aufbringung einer Grundierungsschicht kann eine vorgeschaltete mechanische Glättung der Metallsubstratoberfläche, beispielsweise mittels Schleifens und/oder Polierens bzw. Gleitschleifens, vorgesehen sein. Geschliffene bzw. polierte Metalloberfläche verfügen häufig bereits über eine solche Oberflächengüte, so dass durch Aufbringung der metallischen Kompositschutzschicht gemäß Schritt c) des erfindungsgemäßen Verfahrens ein sehr korrosionsgeschütztes Substrat erhalten wird.

Die erste und/oder die zweite Grundierungsschicht können beispielsweise über ein Nasslackverfahren und/oder ein Pulverbeschichtungsverfahren aufgetragen werden. Geeignet sind zum Beispiel pulverförmige Polyesterharzverbindungen sowie Epoxid/Polyester-Pulver. Geeignete Epoxidharze als Grundierungsschichtmaterialien sind im Handel z.B. unter dem Markennamen "Valophene" bekannt. Als erste und zweite Grundierungsschichten kommen auch solche basierend auf einem Urethanharz, wie in der US 4,431,711 beschrieben, in Betracht. Alternativ kann ebenfalls auf Polyester- oder Polyacrylatmaterialien, wie in der WO 2004/014646 A1 hervorgehoben, zurückgegriffen werden. Ganz besonders bevorzugt wird zum Zweck der Grundierung auf Nasslackverfahren zurückgegriffen. Besonders bevorzugt sind solche Grundierungsverfahren, bei denen die Härtung der Grundierungsschicht nicht thermisch, sondern mittels Strahlungshärtung, beispielsweise UV-Bestrahlung, erfolgt. Bei der Härtung mittels UV-Strahlung ist regelmäßig keine zusätzliche Erwärmung erforderlich, auch wird im Allgemeinen hierbei keine Wärme generiert. Geeignete Pulverlack-, Nasslack- und UV-härtende Beschichtungssysteme sowie deren Aufbringung sind dem Fachmann hinlänglich bekannt. Je nach Oberflächenbeschaffenheit (z.B. porös oder rau) können eine oder mehrere Grundierungsschichten aufgetragen werden, um die Oberfläche zu glätten. Insbesondere mit der ersten Grundierungsschicht, wie sie vorliegend insbesondere auf Metallsubstratoberflächen zum Einsatz kommen kann, wird im Allgemeinen eine vorteilhafte Einglättung der Oberfläche erzielt. Die Grundierungsschicht, insbesondere die erste Grundierungsschicht, stellt somit regelmäßig eine sogenannte Glättungsschicht dar. Mit einer Grundierungsschicht werden im Allgemeinen sämtliche Winkelbereiche erreicht, so dass auch in diesen Bereichen Oberflächenrauhigkeiten ausgeglichen werden können.

Erfindungsgemäß kann ferner vorgesehen sein, eine herkömmliche Konversionsschicht, z.B. wie in der US 2,825,697 oder der US 2,928,763 beschrieben, auf das Substrat aufzutragen.

Stellt das Substrat ein Metallsubstrat dar, hat es sich regelmäßig als vorteilhaft erwiesen, insbesondere wenn dieses Metallsubstrat unmittelbar dem jeweiligen Fertigungsprozess entnommen ist, die Oberfläche des Substrats in geeigneter Weise zu reinigen. Beispielsweise kann in einem ersten vorbereitenden Schritt die Metallsubstratoberfläche mit alkalischen oder sauren Reagenzien entfettet werden. Solche Entfettungsmittel werden unter anderem von der Firma Henkel KGaA unter der Markenbezeichnung Riduline^{®} angeboten. Damit keine Entfettungsreagenzien auf der Oberfläche verbleiben, die die nachfolgenden Bearbeitungsschritte gegebenenfalls beeinträchtigen könnten, schließt sich regelmäßig ein Spülschritt mit Wasser an. Kommerzielle Entfettungsschritte sind auch unter den Begriffen Abkoch- bzw. Beizentfetten bekannt. Alternativ kann eine Metalloberfläche in einem elektrolytischen Entfettungsbad anodisch entfettet werden.

Überdies hat es sich in manchen Fällen als zweckmäßig erwiesen, die Oberfläche des Metallsubstrats, insbesondere die entfettete Metallsubstratoberfläche, mindestens einem Dekapierschritt zu unterziehen. Für die Dekapierung der Metallsubstratoberfläche setzt man z.B. ein saures Spülbad ein. Eine geeignete Dekapierlösung stellt demgemäß z.B. verdünnte Salzsäure (1:10 vol/vol) dar. Im Ergebnis erhält man in der Regel eine im Wesentlichen oxidfreie Metalloberfläche.

Ebenso wie der Entfettungsschritt wird auch der Dekapierschritt im Allgemeinen durch einen Spülschritt abgeschlossen. Hierbei hat es sich als sehr wirksam erwiesen, zumindest gegen Ende des Spülgangs, vorzugsweise während des gesamten Spülgangs, VE-Wasser zu verwenden.

In einer bevorzugten Ausführungsform wird die metallische Schutz- bzw. Kompositschutzschicht gemäß Schritt c) oder die Metallschicht gemäß Schritt c) i) ) des erfindungsgemäßen Verfahrens auf einer entfettenden und/oder dekapierten Metallsubstratoberfläche aufgetragen. Gemäß einer weiteren Ausführungsform kann auch die erste und gegebenenfalls die zweite Grundierungsschicht auf einer entfettenden und/oder dekapierten Metallsubstratoberfläche aufgetragen werden.

Wird die Metallsubstratoberfläche poliert und/oder geschliffen bzw. gleitgeschliffen, kann häufig der Entfettungs- und/oder Dekapierschritt entfallen. Üblicherweise wird bei dieser Art der Oberflächenbearbeitung hinreichend Material von dieser Oberfläche abgetragen, womit dann auch auf der Oberfläche aufliegende bzw. anhaftende Verunreinigungen oder anderweitige Bestandteile mit entfernt werden. Wird die Oberfläche poliert bzw. geschliffen, kann überdies häufig auch auf die Auftragung einer ersten und gegebenenfalls zweiten Grundierschicht verzichtet werden. Mit dem Polieren bzw. Schleifen wird zumeist bereits eine derart ebene bzw. glatte Oberfläche erhalten, dass eine Einglättung durch Aufbringen einer Grundierschicht nicht mehr erforderlich ist. Allenfalls wenn das Metallsubstrat zahlreiche Winkel und Ecken aufweist, die sich nicht ohne weiteres hinreichend polieren bzw. schleifen lassen, kann es empfehlenswert sein, einen ersten und möglicherweise auch einen zweiten Grundierschritt nachzuschalten.

Glas- und Keramiksubstrate sind in der Regel bereits per se so glatt, dass es eines Polierschritts oder der Aufbringung zusätzlicher Grundierschichten nicht bedarf. Dieses trifft im Allgemeinen auch auf Kunststoffsubstrate zu. Sollen Kunststoffsubstrate mit einer besonders glatten Oberfläche, insbesondere mit hoher Zuverlässigkeit, erhalten werden, trägt man zumeist mindestens eine Grundierungsschicht auf. Geeignete Grundierungsschichten für Kunststoffsubstrate stellen z.B. Klarlacke oder UV-Lacke dar. Holzsubstrate, zum Teil auch geschliffene und/oder polierte Holzsubstrate, bedürfen regelmäßig mindestens einer Grundierschicht, bevor die metallische Schutzschicht bzw. die Metallschicht aufgetragen werden kann, und unterfallen daher im Sinne der Erfindung unter Kunststoffsubstrate.

Kunststoffformkörper, die mit dem erfindungsgemäßen Verfahren behandelt werden können, können z.B. gefertigt sein aus ABS, SAN, ASA, PPE, ABS/PPE, ASA/PPE, SAN/PPE, PS, PVC, PC, ABS/PC, PP, PE, EPDM, Polyacrylaten, Polyamiden, POM oder Teflon. Sollte bei diesen Kunststoffkörpern die Aufbringung einer Grundierungsschicht erforderlich sein, werden diese Grundierungsmaterialien bevorzugt im Nasslackverfahren aufgetragen. Bei hoch hitzebeständigen Kunststoffen kommt ebenfalls das Pulverlackverfahren in Kraft.

Gemäß einer weiteren optionalen Ausgestaltung der Erfindung ist vorgesehen, dass vor dem Schritt c) zumindest ein Haftvermittler für die metallische Schutzschicht bzw. die Metallschicht auf die Oberfläche des Substrats, der ersten Grundierungsschicht und/oder der zweiten Grundierungsschicht aufgebracht bzw. auf dieser Oberfläche erzeugt wird. Ein geeigneter Haftvermittler kann z.B. durch mindestens eine Plasmavorbehandlung, vorzugsweise mittels zumindest eines Sauerstoffplasmas und/oder zumindest eines Polymerplasmas, insbesondere umfassend Hexamethyldisiloxan, erzeugt bzw. aufgetragen werden. Auch kann vorgesehen sein, dass als Haftvermittler zumindest ein anorganischer oder metallorganischer Haftvermittler aufgebracht wird. Dabei wird bevorzugt auf ein Zinn(II)-Salz in saurer Lösung oder zumindest ein aminhaltiges Silan in alkalischer Lösung zurückgegriffen.

Vor dem Auftragen der metallischen Schutz- bzw. Kompositschutzschicht gemäß Schritt c) oder der Metallschicht gemäß Schritt c) i) wird die Substratoberfläche vorzugsweise getrocknet, um frei von Wasserresten zu sein.

Vorteilhafterweise werden nach dem Verfahrensschritt c) bzw. dem Verfahrensschritt c) i) die erhaltenen Oberflächen mit Wasser gespült. Bevorzugt wird zumindest gegen Ende dieses Spülschritts, vorzugsweise während des gesamten Spülschritts, vollentsalztes Wasser (auch als VE-Wasser bekannt) verwendet.

Auch kann bei dem erfindungsgemäßen Verfahren vorgesehen sein, dass nach dem Schritt c) bzw. c)ii) zunächst zumindest ein Wärmebehandlungsschritt durchgeführt wird.

Bevorzugt wird vor dem Behandeln der Metallschicht gemäß Schritt c)i) mit dem ersten wässrigen System die Metallschicht mit Wasser, vorzugsweise VE-Wasser, benetzt oder gespült. Vorzugsweise verfügt das hierfür eingesetzte Wasser über einen Leitwert kleiner 100 µS/cm, vorzugsweise kleiner 50 µS/cm und besonders bevorzugt kleiner 35 µS/cm.

Das erste wässrige System kann z.B. in Form einer Lösung, einer Suspension oder einer Emulsion vorliegen. Bevorzugt wird das erste wässrige System als Lösung eingesetzt, d.h. die vorangehend genannten Verbindungen, Salze und/oder Säuren liegen darin zumindest vor der Applikation im Wesentlichen gelöst vor.

Selbstverständlich ist es ebenfalls möglich, dem ersten wässrigen System neben den genannten Verbindungen oder deren Mischungen weitere Bestandteile zuzumischen. Hierfür kommen u.a. Salpetersäure, Fluorsäure, Phosphorsäure, Salze der genannten Säuren, Ammoniumbifluorid und Ammoniumsulfat in Betracht. Ein geeignetes Titansalz stellt z.B. Ammoniumtitanfluorid dar.

Bevorzugt enthält das erste wässrige System Fluoridionen in freier und/oder komplexierter Form. Als geeignete komplexierte Fluoridionen seien Fluoroboratsalze und -säuren sowie Alkalimetall- und Ammoniumbifluoride genannt. Ganz allgemein sind komplexe Fluoride des Titans, Zirkoniums, Hafniums, Siliziums und/oder Bors besonders geeignet. Bevorzugt wird auf Komplexe Fluoride als Zirkoniums zurückgegriffen.

Geeignete erste wässrige Systeme können ferner zusätzlich mindestens eine polymere Verbindung enthalten, die in der wässrigen Zusammensetzung gelöst, in Emulsionsform oder in Form ungelöster dispergierter Partikel vorliegen kann.

Unter den polymeren Verbindungen seien insbesondere die Polyacrylsäure sowie deren Salze und Ester genannt. Diese Säuren, Ester und Salze können in der wässrigen Lösung in gelöster oder in dispergierter Form vorliegen. Die Menge an Polymerkomponente kann in weiten Bereichen variiert werden und liegt vorzugsweise im Bereich von 0,1 bis 0,5 g pro Liter.

Als polymere Materialien kommen des Weiteren Polymethylvinylinaleinsäure und Polymethylvinylmaleinsäureanhydrid in Frage. Geeignete Polyacrylsäuren verfügen idealerweise über ein Molekulargewicht von bis zu 500.000. Bevorzugt wird auch häufig auf Mischungen in Frage kommender Polymerverbindungen zurückgegriffen. Beispielsweise seien Mischungen enthaltend Polyacrylsäure, deren Salze oder Ester mit Polyvinylalkohol genannt. Geeignete Polymere umfassen ferner Hydroxyethylether der Cellulose, Ethylenmaleinsäureanhydrid, Polyvinylpyrolidin und Polyvinylmethylether.

Besonders bevorzugte polymere Komponenten im Sinne der vorliegenden Erfindung umfassen einen quervernetzten Polyester, enthaltend eine Vielzahl an Carbonsäurefunktionalitäten und eine Vielzahl an Hydroxylgruppen, die teilweise oder vollständig miteinander reagiert haben können. Bei diesem quervernetzten Polyesterpolymer kann es sich z.B. um das Reaktionsprodukt eines ersten Polymers, enthaltend Carbonsäurefunktionalitäten, mit einem zweiten Polymer, enthaltend Hydroxylgruppen, handeln. Beispielsweise kommen Polyacrylsäure und Polymethylvinylinaleinsäureanhydrid als solche ersten Polymere in Betracht, während Polyvinylalkohol ein geeignetes zweites Polymer darstellt. Interessanterweise eignet sich sowohl das Reaktionsprodukt der vorangehend genannten ersten und zweiten Polymere als auch deren Mischung als Bestandteil des ersten wässrigen Systems zur Behandlung nach dem erfindungsgemäßen Verfahren. Überdies kann eine solche erste wässrige Lösung zusätzlich vorzugsweise Fluorsäure enthalten. Als geeignete Salze der genannten Polyacrylsäure kommen z.B. Ammoniumsalze in Frage.

Außerdem kommt als geeignetes Polymer 3-(N-C₁₋₄-Alkyl-N-2-hydroxethylaminomethyl)-4-hydroxystyrol in Betracht, insbesondere wenn zusammen mit Hexafluorzirkonsäure eingesetzt. Zusätzlich kann gegebenenfalls auch das Homopolymer des 4-Hydroxystyrols zugegen sein, mit einem mittleren Molekargewicht im Bereich von 3000 bis 6000. Diesbezügliche Details können der US 5,089,064 entnommen werden.

Die ersten wässrigen Systeme können des Weiteren Fettsäuren, Fettalkohole und/oder insbesondere Fettamine oder deren beliebige Mischungen enthalten. Die Fettamine können auch in Form ihrer Ammoniumsalze vorliegen. Fettamine im Sinne der vorliegenden Erfindung umfassen somit auch die korrespondierenden Ammoniumsalze. Hierbei wird bevorzugt auf Verbindungen mit gesättigten Fettalkylketten zurückgegriffen. Die Länge der linearen Fettalkylketten liegt bevorzugt im Bereich von C₈ bis C₂₄. Bevorzugte Fettamine bzw. die entsprechende Ammoniumverbindungen basieren auf einem C₁₂-, C₁₄-, C₁₆- oder C₁₈-Alkylrest. Geeignete Fettsäuren umfassen z.B. Caprinsäure.

Darüber hinaus können geeignete erste wässrige Systeme mit Polyoxyalkylenglycolether, insbesondere Polyoxyethylenglycolethern, Polypropylenglycolethern und deren Mischungen, versetzt sein. Hierbei kann auf alle gängigen kommerziell erhältlichen Glycolether zurückgegriffen werden.

Geeignete pH-Werte für die ersten wässrigen Systeme liegen bzw. werden vorzugsweise im Bereich von 1,5 bis 6,5, bevorzugt im Bereich von 1,5 bis 5,0, und insbesondere von 2,0 bis 4,5 gehalten. Soll der pH-Wert der wässrigen Systeme angehoben werden, eignen sich hierfür vor allem Gaben an Ammoniak oder Ammoniumhydroxid, z.B. in Form einer 3%-igen Ammoniaklösung. Daneben kann auf konventionelle, dem Fachmann bekannte Basen zurückgegriffen werden.

Der Leitwert des eingesetzten ersten wässrigen Systems liegt vorzugsweise im Bereich von 100 bis 2000, besonders bevorzugt im Bereich von 150 bis 1500 und insbesondere im Bereich von 200 bis 1000 µS/cm.

Die vorangehend beschriebenen optionalen Komponenten des ersten wässrigen Systems können in einer Ausführungsform, einzeln oder in beliebiger Kombination, ebenfalls in der Metallschicht vorliegen und dann ebenfalls Bestandteil der metallischen Kompositschutzschicht sein.

Gemäß einer vorteilhaften Ausgestaltung der vorliegenden Erfindung ist vorgesehen, dass nach dem Aufbringen der Metallschicht gemäß Schritt c) i) und vor dem Behandlungsschritt c)ii) und/oder nach Schritt c), jeweils insbesondere unmittelbar, das so beschichtete Substrat einem Spülschritt mit, insbesondere vollentsalztem, Wasser unterzogen wird. Hieran schließt sich vorzugsweise jeweils mindestens ein Trocknungsschritt zum Trocknen der Oberfläche an. Der Trocknungsschritt kann z.B. bei Temperaturen im Bereich von 120 bis 180°C, beispielsweise bei etwa 140°C, durchgeführt werden. Das zum Spülen eingesetzte Wasser verfügt vorzugsweise über einen Leitwert kleiner 60 µS/cm, vorzugsweise kleiner 50 µS/cm und insbesondere kleiner 35 µS/cm. Insbesondere der jeweils letzte Spülgang vor dem nachfolgenden Verfahrensschritt oder vor einem Trocknungsvorgang verfügt über die voranstehend genannten Leitwerte.

Der pH-Wert und/oder der Leitwert des ersten wässrigen Systems werden für die Dauer der Behandlung der Metallschicht vorzugsweise im Wesentlichen konstant gehalten, insbesondere innerhalb der vorangehend genannten Bereiche.

Das mit der Metallschicht versehene Substrat kann z.B. mittels Eintauchens, Spülens oder Besprühens mit dem vorangehend beschriebenen ersten wässrigen System, enthaltend mindestens eine der genannten Verbindungen des zweiten Metalls, behandelt werden. Bevorzugt wird die Metallschicht unter erhöhtem Druck mit diesem ersten wässrigen System beaufschlagt, beispielsweise in Form von Hochdruckwasserstrahlen. Hierbei hat es sich als zweckmäßig erwiesen, eine Vielzahl an feinen Einzelwasserstrahlen auf das Substrat zu richten. Die Variante des Besprühens mit dem ersten wässrigen System hat sich demgemäß als besonders zweckmäßig erwiesen. Geeignete Drücke für die Beaufschlagung mit dem ersten wässrigen System liegen z.B. oberhalb von 0,2 bar, vorzugsweise im Bereich von 0,5 bis 50 bar und besonders bevorzugt im Bereich von 0,2 bis 15, insbesondere von 0,9 bis 1,5 bar. Diese Drücke werden auf der Oberfläche der Metallschicht gemessen. Auch mit der vorangehend beschriebenen Variante kann mindestens eine Säure, ein Oxid, Doppeloxid, Oxid-Hydrat, Halogenid, Oxyhalogenid und/oder Salz eines zweiten Metalls, vorzugsweise Zirkonium oder Titan, in die Metallschicht eingetragen werden.

Geeigneterweise liegt die Temperatur des ersten wässrigen Systems beim Behandlungsvorgang des Substrats im Bereich von 15 bis 50°C, bevorzugt im Bereich von 20 bis 40°C. In der Regel reicht bereits eine Behandlungsdauer von 20 bis 120 Sekunden aus, um das erfindungsgemäße Substrat zu erhalten.

Bevorzugt wird das mit einer Metallschicht, insbesondere mit einer Aluminiumschicht, gemäß Schritt c)i) versehene Substrat unmittelbar nach deren Aufbringung auf die Substratoberfläche mit dem beschriebenen wässrigen ersten System, wie vorangehend geschildert, behandelt. Diese Vorgehensweise gelingt beispielsweise in einer Fertigungsstraße, in der das Substrat sukzessive sämtliche Fertigungsstufen durchläuft.

In einer bevorzugten Ausführungsform liegt der Anteil an Eisenionen in dem ersten wässrigen System nicht oberhalb 10 ppm.

Für die Silanisierung der Kompositschutzschicht kann vorgesehen sein, dass der Schritt d) die Behandlung der Kompositschutzschicht aus Schritt c) mit einem zweiten wässrigen System enthaltend mindestens eine zu Polykondensations- und/oder Polyadditionsreaktionen befähigte Silanverbindung, insbesondere hydrolysierbare und/oder zumindest teilweise hydrolysierte Silane, umfasst.

In einer geeigneten Ausführungsform liegt das zweite wässrige System alkalisch vor und verfügt bevorzugt über einen pH-Wert von 8 bis 12, vorzugsweise von 9 bis 11.

Die Silanisierung in Schritt d) ) wird in einer besonders zweckmäßigen Ausgestaltung derart durchgeführt, dass man durchschnittliche Schichtdicken im Bereich von 5 nm bis 2 µm, insbesondere bis 1 µm, erhält. Selbstverständlich sind auch größere durchschnittliche Schichtdicken, beispielsweise bis 30 µm und darüber möglich. Im Allgemeinen wählt man häufig durchschnittliche Schichtdicken im Bereich von 0,1 µm bis 2 µm oder 0,2 µm bis 0,8 µm.

Der Silanisierungschritt lässt sich im Allgemeinen unterteilen in einen Applikationsschritt, in dem die Kompositschutzschicht mit dem zweiten wässrigen System behandelt wird, einen Trocknungsschritt, in dem das Wasser bzw. Lösungsmittel entfernt wird und einen Aushärtschritt. Trocknungs- und Aushärtschritt können in einer Ausführungsform auch zu einem einzigen Schritt vereint sein. Bei dem Aushärtschritt finden regelmäßig Polyadditions- bzw. Kondensationsreaktionen statt. Für den Aushärtschritt können beispielsweise Temperaturen im Bereich von 120 bis 350°C zur Anwendung gelangen, z.B. für einen Zeitraum im Bereich von 15 bis 60 Minuten.

Demgemäß kann ferner vorgesehen sein, dass die Silanisierung gemäß Schritt d) die Ankopplung von Silanverbindungen an die aufgedampfte bzw. aufgesputterte Metalloberfläche und die Polykondensation von angekoppelten Silanverbindungen untereinander und gegebenenfalls von angekoppelten Silanverbindungen mit nicht an die Metalloberfläche angekoppelten Silanverbindungen umfasst.

Geeignete Silanverbindung für die Silanisierung umfassen funktionalisierte hydrolysierbare und/oder partiell und/oder vollständig hydrolisierte Alkoxysilane, vorzugsweise enthaltend Amino-, Acryl-, Vinyl- und/oder Epoxygruppen, besonders bevorzugt Aminoalkyltrialkoxysilane, z.B. Aminoalkyltriethoxysilane bzw. 3-Aminopropyltriethoxysilan.

Exemplarisch seien als geeignete Silanverbindungen auch genannt die Silanverbindungen 3-Glycidoxypropyltri(m)ethoxysilan, 3,4-Epoxybutyltri(m)ethoxysilan, 2-(3,4-Epoxycyclohexyl)ethyltri(m)ethoxysilan, 3-(Meth)acryloxypropyltri(m)ethoxysilan, 2-(Meth)acryloxyethyltri(m)ethoxysilan, 3-Glycidoxypropyldimethyl(m)ethoxysilan, 3-Glycidoxypropylmethyldi(m)ethoxysilan, 3-(Meth)acryloxypropylmethyldi(m)ethoxysilan, 2-(Meth)acryloxyethylmethyl-di(m)ethoxysilan und beliebige Mischungen dieser Verbindungen genannt.

Geeignete Polysiloxane können auch teil- oder perfluorierte Siloxane umfassen.

Zusätzlich zu mit mindestens einer funktionellen Gruppe versehenen Silanverbindungen, welche an die Oberfläche der Kompositschutzschicht ankoppeln können, können bei der Silanisierung auch Silanverbindungen ohne solche funktionellen Kopplungseinheiten eingesetzt werden, beispielsweise Hexadecyltri(m)ethoxysilan, Cyclohexyltri(m)ethoxysilan, Cyclopentyltri(m)ethoxysilan, Ethyltri(m)ethoxysilan, Phenylethyltri(m)ethoxysilan, Phenyltri(m)ethoxysilan, n-Propyltri(m)ethoxysilan, Cyclohexyl(m)ethyldimethoxysilan, Dimethyldi(m)ethoxysilan, Diisopropyldi(m)ethoxysilan Phenylmethyldi(m)ethoxysilan oder deren beliebige Mischungen.

In einer besonders bevorzugten Ausgestaltung wird die Silanisierung gemäß Schritt d) nicht als No-Rinse Verfahren durchgeführt. D.h. bevorzugt wird die Silanisierung gemäß Schritt d) durch Spülen mit Wasser, vorzugsweise entsalztem Wasser, z.B. VE-Wasser, unterbrochen. Diesem Spülschritt kann ein Abtropfschritt vorgeschaltet sein.

Es hat sich ferner in einer Ausgestaltung des erfindungsgemäßen Verfahren als zweckmäßig erwiesen, wenn bei der Silanisierung Silanverbindungen eingesetzt werden mit funktionellen Gruppen, die beim Silanisierungsschritt nicht oder nicht vollständig abreagieren und die bei der Herstellung der Deck- bzw. Lackschicht mit dieser mindestens eine kovalente Bindung eingehen. Demgemäß hat es sich in einer Ausführungsvariante als zweckmäßig erwiesen, auch auf solche Materialien für die Deck- bzw. Lackschicht zurückzugreifen, die mindestens eine Silanverbindung, vorzugweise mindestens eine zu Polykondensations -und/oder Polyadditionsreaktionen befähigte Silanverbindung, insbesondere über hydrolysierbare und/oder zumindest teilweise hydrolysierte Silane, enthalten. Hierbei können in einer Ausführungsform die vorangehend für das zweite wässrige System spezifizierten Silanverbindungen, einzeln oder in einer beliebigen Mischung, zum Einsatz kommen.

Auch ist es von Vorteil, wenn in einer Ausgestaltung des erfindungsgemäßen Verfahrens die beschichtbare Oberfläche des Substrats vor Aufbringung der mindestens einen Metallschicht oder der ersten und/oder zweiten Grundierschicht mindestens einem Entfettungsschritt, insbesondere umfassend die Behandlung mit einem sauren und/oder einem basischen Entfettungsmittel und/oder Behandlung mit einem anodischen Entfettungsbad, gegebenenfalls gefolgt von einem Spülschritt mit Wasser, insbesondere entsalztem Wasser, und/oder mindestens einem Dekapierschritt, gegebenenfalls gefolgt von einem Spülschritt mit Wasser, insbesondere entsalztem Wasser, unterworfen wird.

Dadurch, dass der Silanisierungsschritt durch Spülen mit Wasser unterbrochen wird, erhält man regelmäßig eine noch bessere Haftung der sich hieran anschließenden Deck- bzw. Schutzlackschicht. Darüber hinaus gelingt es auf diese Weise noch besser, auch geometrisch anspruchsvolle Bauteile zuverlässig und wiederholbar zu beschichteten, um auf diese Weise ein sehr korrosionsbeständiges und/oder glänzendes beschichtetes Bauteil zu erhalten.

In einer bevorzugten Ausführungsform des erfindungsgemäßen Verfahrens ist vorgesehen, dass das, vorzugsweise entfettete, Substrat, das bereits, vorzugsweise auf einer ersten bzw. gegebenenfalls zweiten Grundierungsschicht, mit einer aufgedampften oder aufgesputterten Metallschicht versehen worden ist, mit dem ersten wässrigen System besprüht wird, vorzugsweise für eine Zeitdauer im Bereich von 3 bis 120 Sekunden, besonders bevorzugt für eine Zeitdauer im Bereich von 10 bis 60 Sekunden. Nach der Behandlung mit dem ersten wässrigen System wird bei dieser bevorzugten Ausführungsform das beschichtete Substrat mit Wasser, insbesondere entsalztem Wasser, beispielsweise VE-Wasser gespült, insbesondere mittels Sprühens. Sodann schließt sich bei dieser vorteilhaften Ausführungsform, vorzugsweise nachdem man das Spülwasser hat abtropfen lassen, die Behandlung mit dem zweiten wässrigen System, vorzugsweise ebenfalls mittels Besprühens, an. Die Behandlungsdauer mit dem zweiten wässrigen System wird vorzugsweise auf einen Zeitraum im Bereich von 5 bis 180 Sekunden, besonders bevorzugt auf eine Zeitraum im Bereich von 25 bis 120 Sekunden und ganz besonders bevorzugt auf eine Zeitdauer im Bereich von 40 bis 90 Sekunden, eingestellt. Die Zeitdauer der Behandlung mit dem zweiten wässrigen System wird regelmäßig in Abhängigkeit der angestrebten Dicke der Siloxanschicht eingestellt. An die Behandlung mit dem zweiten wässrigen System schließt sich, gegebenenfalls unter Zwischenschaltung eines Abtropfschritts, ein Spülschritt mit Wasser, vorzugsweise entsalztem Wasser, beispielsweise VE-Wasser, an. Mit dem erfindungsgemäßen Verfahren lässt sich, insbesondere wenn unter Beachtung der vorangehend spezifizierten bevorzugten Ausführungsvariante durchgeführt, eine sehr hohe Prozessgenauigkeit unter Erlangung einer sehr gleichmäßigen Schichtdicke der Siloxanschicht erzielen. Zudem stellt sich eine besonders gute Haftung der sich anschließenden Deck- bzw. Schutzlackschicht ein. Dieses gilt auch für geometrisch sehr anspruchsvolle Bauteile.

Mit der Erfindung wird auch vorgeschlagen, dass nach dem Schritt c) bzw. c)ii) zumindest eine, insbesondere transparente, Lack- bzw. Deckschicht aufgebracht wird. Dieses kann z.B. ein Schutzlack bzw. Klarlack oder ein transparentes Pulver sein, welche vorzugsweise über ein Nasslack- bzw. ein Pulverbeschichtungsverfahren aufgetragen werden. Ferner sieht die Erfindung vor, dass die Lack- bzw. Deckschicht, insbesondere der Schutzlack, mindestens einen Farbstoff oder ein Pigment enthalten kann.

Als Lack- bzw. Deckschicht kann auch auf dem Fachmann bekannte Lasuren zurückgegriffen werden. Hiermit lassen sich z.B. Messing-, Titan- und Goldtöne sowie individuelle Farbtöne wie rot, blau, gelb, grün, etc. und sämtliche Eloxalfarben ohne weiteres einstellen.

Die der Erfindung zugrunde liegende Aufgabe wird des Weiteren gelöst durch ein metallisch beschichtetes Substrat, insbesondere korrosionsgeschütztes und/oder glänzendes metallisch beschichtetes Substrat, umfassend, in dieser Reihenfolge,
ein Substrat;
mindestens eine metallische Kompositschutzschicht, enthaltend als Hauptkomponente mindestens ein erstes Metall ausgewählt aus der Gruppe, bestehend aus Aluminium, Mangan, Magnesium, und Zink, oder mindestens eine erste Metalllegierung ausgewählt aus der Gruppe, bestehend aus Stahl, Edelstahl, einer Magnesiumlegierung und einer Aluminiumlegierung, und in dieser Hauptkomponente verteilt vorliegend als Minderkomponente mindestens ein zweites Metall und/oder mindestens ein oxydisch gebundenes zweites Metall, ausgewählt aus der Gruppe, bestehend aus Zirkonium, Titan und Hafnium, oder bestehend aus der mindestens einen Hauptkomponente und der mindestens einen Minderkomponente, wobei das erste Metall oder die erste Metalllegierung mittels Aufdampf- und/oder Sputter-Technik in Form einer Metallschicht aufgebracht worden ist;
mindestens eine, insbesondere unmittelbar auf der Kompositschutzschicht vorliegende oder an die Kompositschutzschicht zumindest partiell kovalent angebundene, Polysiloxanschicht;
mindestens eine, insbesondere unmittelbar auf der Polysiloxansicht vorliegende oder an die Polysiloxanschicht zumindest partiell kovalent angebundene, Lackschicht;
oder
ein Substrat;
mindestens eine Metallschicht, enthaltend mindestens ein erstes Metall ausgewählt aus der Gruppe, bestehend aus Aluminium, Mangan, Magnesium und Zink, oder mindestens eine erste Metalllegierung ausgewählt aus der Gruppe bestehend aus Stahl, Edelstahl, einer Magnesiumlegierung und einer Aluminiumlegierung, wobei das erste Metall oder die erste Metalllegierung mittels Aufdampf- und/oder Sputter-Technik in Form einer Metallschicht aufgebracht worden ist;
mindestens eine, insbesondere unmittelbar auf der Metallschicht vorliegende oder an die Metallschicht zumindest partiell kovalent angebundene, Polysiloxanschicht; und mindestens eine, insbesondere unmittelbar auf der Polysiloxanschicht vorliegende oder an die Polysiloxanschicht zumindest partiell kovalent angebundene, Lackschicht.

Vorzugsweise handelt es sich bei den erfindungsgemäßen beschichteten Substraten um solche, die nach dem erfindungsgemäßen Verfahren erhalten worden sind.

Die erfindungsgemäßen Substrate können beispielsweise als Spiegel, verspiegeltes Material oder als Zubehörteil für den Automobilbaubereich verwendet werden. Möglich ist auch die Verwendung als Leichtmetallfelge bzw. Leichtmetallrad für den Automobilbaubereich. Selbstverständlich können auch Karosseriebauteile, seien sie aus Kunststoff oder Metall, mit dem erfindungsgemäßen Verfahren mit einer metallischen Schutz- bzw. Kompositschutzschicht versehen werden. Die erfindungsgemäßen Substrate sind natürlich nicht auf die genannten Verwendungen beschränkt.

Die vorliegende Erfindung umfasst demgemäß metallisch beschichtete metallische und nicht-metallische Substrate, umfassend, in dieser Reihenfolge, ein Substrat, beispielsweise aus Kunststoff, Aluminium oder einer Aluminiumlegierung, und eine metallische Schutz- bzw. Kompositschutzschicht, wie vorangehend beschrieben, insbesondere auf der Basis von Aluminium. Gegebenenfalls liegt in dieser Ausführungsform die mit der metallischen Schutz- bzw. Kompositschutzschicht zu versehene Substratoberfläche in geschliffener und/oder polierter Form vor. In einer weiteren, bevorzugten Ausführungsform umfasst die erfindungsgemäße beschichtete Struktur, in dieser Reihenfolge, ein Substrat, vorzugsweise mit einer geschliffenen und/oder polierten Substratoberfläche, eine, gegebenenfalls chromfreie, Konversionsschicht und eine metallische Schutz- bzw. Kompositschutzschicht, wie vorangehend beschrieben. Gemäß einer weiteren vorteilhaften Ausgestaltung verfügt ein erfindungsgemäßes beschichtetes Substrat, in dieser Reihenfolge, über ein Substrat, gegebenenfalls mit polierter und/oder geschliffener Oberfläche, eine erste und gegebenenfalls eine zweite Grundierungsschicht und eine metallische Schutz- bzw. Kompositschutzschicht, wie vorangehend beschrieben. Des Weiteren umfasst ein alternatives erfindungsgemäß beschichtetes Substrat, in dieser Reihenfolge, ein Substrat, gegebenenfalls mit polierter und/oder geschliffener Substratoberfläche, eine, vorzugsweise chromfreie, Konversionsschicht, eine erste Grundierungsschicht sowie gegebenenfalls eine zweite Grundierungsschicht, und eine metallische Schutz- bzw. Kompositschutzschicht, wie vorangehend beschrieben.

Das erfindungsgemäße Verfahren sowie die erfindungsgemäßen Substrate sind in einer bevorzugten Ausführungsform chromfrei, d.h. die Kompositschutzschicht oder die Metallschicht enthalten kein Chrom, weder als Metall noch ihn Form einer Chromverbindung, z.B. als Oxid oder Salz. Darüber hinaus können auch die Substrate in einer bevorzugten Variante kein Chrom bzw. keine Chromverbindungen enthalten.

Die semiquantitative Darstellung der lateralen Verteilung der Elemente der Kompositschutzschicht, z.B. Zr, Al und O, kann man durch Auswertung eines EDX-Elementmaps (EDX = energiedispersive Röntgenmikroanalyse) erhalten. Hierbei wird die energiedispersive Röntgenmikroanalyse gekoppelt mit der ESEM-Technik (Environmental Scanning Electron Microscopy; Rasterelektronenmikroskopie) genutzt (z.B. mit einer Anregungsspannung von 10 keV). Die Abbildung erfolgt mit Sekundärelektronen (SE-Topographiekontrast) oder mit Rückstreuelektronen (BSE-Materialkontrast). Für die EDX-Aufnahme, wie auch für die weiteren nachfolgend dargestellten Messverfahren, empfiehlt es sich, einen Mikrotom-Schrägschnitt unter flachem Winkel (z.B. Streckungsfaktor von ca. 400) von dem Probenkörper anzufertigen. Denn um eine ausreichende Messfläche bzw. -strecke zur Verfügung zu haben, hat man regelmäßig die untersuchte Probe schräg anzuschneiden. Auf diese Weise gelingt es, eine sich über die z.B. nur etwa 100 nm dicke metallische Kompositschutzschicht 11 erstreckende Meßstrecke auf etwa 400 µm auszudehnen. Bei diesem Anschneidevorgang kann regelmäßig nie vollständig verhindert werden, dass auch Material anderer Schichten in benachbarte Schichten eingetragen bzw. verschmiert wird.

Zur Bestätigung des Ergebnisses der EDX-Messung bzw. alternativ kann man auch eine Linescan-Untersuchung über die Oberfläche eines Mikrotom-Rumpfschnittes vornehmen. Hierbei werden an diskreten, aufeinander folgenden Messpunkten TOF-SIMS-Messungen durchgeführt. Eine Normierung kann dabei über die Summe der Intensitäten ausgewählter Kohlenwasserstoffsignale erfolgen. Über eine Linescan-Länge von z.B. 600 µm kann man beispielsweise 20 Messpunkten die Intensität charakteristischer Signale massenspektroskopisch untersuchen. Der Linescan kann sich hierbei ohne weiteres über die gesamte Breite der metallischen Kompositschutzschicht erstrecken und zusätzlich die sich an die Schutzschicht anschließenden Abschnitte der Deckschicht und der Grundierungsschicht abdecken. Bei TOF-SIMS handelt es sich um ein Verfahren der Flugzeit-Sekundärionen-Massenspektrometrie zum hochempfindlichen Nachweis von Elementen und anorganischen sowie organischen Verbindungen an Materialoberflächen. Hiermit sind ortsaufgelöste Analysen im µm- und nm-Bereich möglich.

Anhand von XPS-Spektren lassen sich die Bindungszustände von Komponenten der Kompositschutzschicht ermitteln. Denn die X-Ray Excited Photoelectron Spectroscopy (XPS) erlaubt bei Festkörpern neben der quantitativen Identifizierung der in unmittelbarer Oberflächennähe vorliegenden Elemente ebenfalls die Ermittlung von Bindungszuständen. Über eine XPS-Tiefenprofilanalyse der Kompositschutzschicht erhält man Aufschluss über die Verteilung der zweiten Metalle in der Metallschicht aus dem ersten Metall.

Der Erfindung liegt die überraschende Erkenntnis zugrunde, dass durch das erfindungsgemäße Verfahren ein Substrat mit einer metallischen Schutzbeschichtung bereitgestellt wird, das eine ausgezeichnete Korrosionsbeständigkeit sowie eine sehr ansprechende Chrom-Optik aufweist. Unter einer Chrom-Optik soll vorliegend eine solche verstanden werden, die sich üblicherweise nur bei der galvanischen Verchromung von Substraten einstellt. Eine derartige Optik ist mit den aus dem Stand der Technik bekannten Verfahren nicht erreichbar. Mit dem Verfahren der vorliegenden Erfindung kann ein haftfest beschichtetes, korrosionsgeschütztes, hochglänzendes Substrat auch mit komplexer Geometrie erhalten werden, das optisch mit galvanisch verchromten Substraten identisch ist und darüber hinaus gleichzeitig alle Testanforderungen der Automobilindustrie erfüllt. Insbesondere kann eine besonders gute Haftung der Schutz- bzw. Deckschicht erzielt werden.

Die erfindungsgemäßen Substrate zeigen überragende Korrosionsbeständigkeiten, und zwar selbst dann, wenn die Oberflächen mechanische Beschädigungen erfahren haben, beispielsweise mittels Steinschlag oder durch Anritzen. Insbesondere war auch nicht zu erwarten, dass sich Metallsubstrate, insbesondere Aluminiumsubstrate erhalten lassen, die Glanzteile darstellen, wie sie üblicherweise nur bei besonders hochwertigen Chrombauteilen anzutreffen sind. Die vorteilhaften Effekte hinsichtlich Korrosionsbeständigkeit und Glanz stellen sich natürlich auch dann ein, wenn auf die Anbringung einer Grundierungsschicht auf dem Substrat verzichtet wird.

Gegenüber herkömmlichen Verfahren zeichnen sich das erfindungsgemäße Verfahren und die erfindungsgemäßen beschichteten Substrate durch die Verwendung ökologisch unbedenklicher Bestandteile aus. Das erfindungsgemäße Verfahren kann für die Herstellung vielfältigster Glanzbauteile verwendet werden. Exemplarisch seien genannt Radfelgen, wie beispielsweise Automobil-, Motorrad- und Fahrradfelgen, Ziergegenstände jeglicher Art, z.B. Zierleisten, Karosserieaußen- und -innenbauteile, wie Rückspiegelabdeckungen, Frontblenden, Motorhaubenabdeckungen und Konsolen, Sanitäreinrichtungsgegenstände, wie Armaturen, und Reflektorflächen, beispielsweise bei Scheinwerfern, insbesondere Automobilscheinwerfern. Ferner können jegliche Art von Griffen, beispielsweise Türgriffe, sowie jegliche Art von Rahmen, beispielsweise Fensterrahmen, und auch Verpackungsgegenstände und Gehäuse, beispielsweise aus der Kosmetikartikelindustrie, beispielsweise Lippenstiftgehäuse, nach dem erfindungsgemäßen Verfahren gefertigt sein. Darüber hinaus können beispielsweise vielfältigste Komponenten von Motor- und Fahrrädern oder sonstigen Fortbewegungsmitteln, Bauteilkomponenten, wie sie in der Möbelindustrie Verwendung finden, Rohre, Handtuchhalter, Heizkörper, Bauteile von Aufzügen, Innen- und Außenbauteile von Flugzeugen, jedwede Reflektoren, Schmuckgegenstände, Handyschalen oder Bauteile, wie sie im Hausbau zum Einsatz kommen, nach dem erfindungsgemäßen Verfahren beschichtet sein. Besonders geeignet sind die erfindungsgemäßen beschichteten Substrate auch für den Einsatz im Schiffbau und können sowohl für Innen- wie auch insbesondere für Außenbauteile verwendet werden. Hierbei zeigt sich die Güte der erfindungsgemäß beschichteten Produkte daran, dass eine langanhaltende Korrosionsbeständigkeit und damit einhergehend ein hochwertiger chromähnlicher Glanz auch durch Meerwasser, beispielsweise Gischt, nicht beeinträchtigt wird.

Von besonderem Vorteil ist überdies, dass Probleme aufgrund unterschiedlicher Dehnungskoeffizienten, wie sie bei galvanisch verchromten Substraten regelmäßig beobachtet werden, nicht mehr auftreten. Die nach dem erfindungsgemäßen Verfahren beschichteten Substrate neigen nicht mehr bzw. nicht mehr so ausgeprägt zur Rissbildung oder zum Abplatzen. Somit sind beispielsweise hochglänzende Kunststoffsubstrate zugänglich, die für vielfältigste Anwendungen, beispielsweise im Automobilbau oder bei der weißen Ware, zum Einsatz kommen können.

Die nach dem erfindungsgemäßen Verfahren beschichteten Substrate erfüllen regelmäßig die geforderten Sollwerte beim Chemikalienbeständigkeitstest nach VDA-Prüfblatt 621-412 (Prüfung A). Ferner zeigen diese erfindungsgemäßen Substrate im Allgemeinen im Salzsprühnebeltest gemäß DIN 50021-CASS (Kupferchlorid/Essigsäure) auch nach 240 Stunden keine Veränderung der Oberfläche. Demgegenüber wird mit dem Mehrschichtsystem der US 6,896,970 B2, beim eine Konversionsschicht auf einer Schichtstruktur aus Polymerschicht und Metallschicht vorliegt, bei dem CASS-Test bereits nach 168 Stunden eine Veränderung der Oberfläche festgestellt. Auch werden bei den erfindungsgemäßen Substraten Blasenbildung und Grundmetallkorrosion nicht beobachtet. Darüber hinaus erzielen die erfindungsgemäß beschichteten Substrate im Steinschlagtest nach PV 1213 regelmäßig Kennwerte im Bereich von 0 bis 0,5. Zudem ergibt auch die Kondenswasserkonstantklimaprüfung nach DIN 50017 nach 240 Stunden keine Veränderung der Oberfläche. Schließlich zeigen diese beschichteten Substrate auch im Freibewitterungstest (Florida-Test) über einen längeren Bewitterungszeitraum von mehreren Monaten keine Veränderung. Der Glanzerhalt gemäß DIN 67530 beträgt in der Regel nahezu 100%. Der Gitterschnittkennwert gemäß Gitterschnitttest nach DIN EN ISO 2409 beträgt regelmäßig Gt 0.

Die nach dem erfindungsgemäßen Verfahren erhaltenen beschichteten Substrate erfüllen häufig sowohl die Anforderungen, die von der Automobilindustrie an die Beständigkeit der Beschichtung gestellt werden, als auch z.B. die Anforderungen, die vom Gesetzgeber zur Zulassung des Beschichtungssystems für die Behandlung von Autofelgen gestellt werden. Des Weiteren führt das erfindungsgemäße Verfahren zu einer optisch qualitativ hochwertigen Beschichtung, dass mit einem vergleichsweise geringen Aufwand eine sehr widerstandsfähige Oberfläche mit einer Chrom-Optik erzeugt.

Das erfindungsgemäße Verfahren weist insbesondere die Vorteile auf, dass es nicht notwendig ist, die zu beschichtenden Substrate, z.B. Leichtmetallfelgen, auf Hochglanz zu polieren, was bei komplexen Geometrien nur mit sehr hohem Aufwand, wenn nicht sogar ganz unmöglich ist. Die Vorbereitung des Substrats ist somit wesentlich weniger aufwendig. Hervorzuheben ist ferner die Umweltfreundlichkeit des erfindungsgemäßen Verfahrens, da Lösemittelemissionen im Wesentlichen vollständig vermieden werden. Das erfindungsgemäße Verfahren liefert ein beschichtetes Substrat mit beständigem Korrosionsschutz auch bei Verletzung oder Beschädigung des Schichtsystems bis hin zum Substrat. Dadurch wird die Lebensdauer des erfindungsgemäßen beschichteten Substrats deutlich erhöht. Insbesondere beim Einsatz der erfindungsgemäßen Substrate im Automobilbereich, wie als Leichtmetallfelgen oder Reflektoren für Scheinwerfer, wirkt sich diese Widerstandsfähigkeit positiv aus. Ferner ergeben solche Substrate eine hervorragende Optik und damit einen Zusatznutzen im Produktdesign beispielsweise bei Verwendung des Substrats als Rad bzw. Felge. Insgesamt werden die Gesamtoptik des Automobils und damit eine optische Abgrenzung von Standardausführungen verbessert.

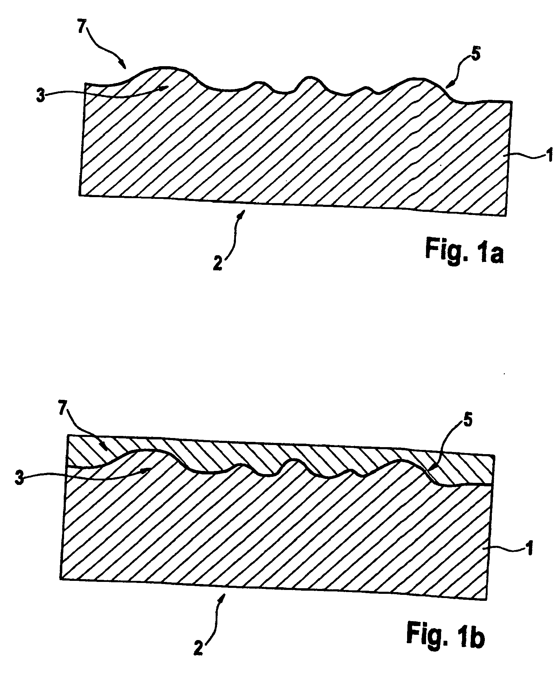

Weitere Merkmale und Vorteile der Erfindung ergeben sich aus der nachfolgenden Beschreibung, in der Ausführungsbeispiele der Erfindung anhand schematischer Zeichnungen im Einzelnen erläutert sind. Dabei zeigen
- Figur 1a: eine schematische Querschnittsansicht eines erfindungsgemäßen beschichteten Substrats vor der Durchführung des erfindungsgemäßen Verfahrens,
- Figur 1b: das Substrat der Figur 1a nach Aufbringen einer Grundierungsschicht;

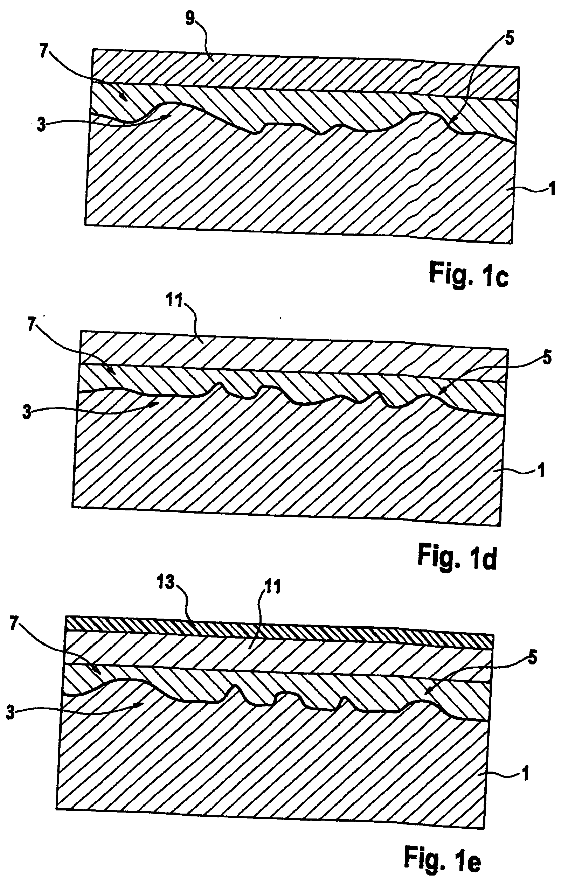

- Figur 1c: das Substrat der Figur 1b nach Aufbringen einer Metallschicht;
- Figur 1d: das Substrat gemäß Figur 1c, enthaltend eine metallische Schutz- bzw. Kompositschutzschicht;
- Figur 1e: das Substrat gemäßn Figur 1d, enthaltend eine Polysiloxanschicht; und

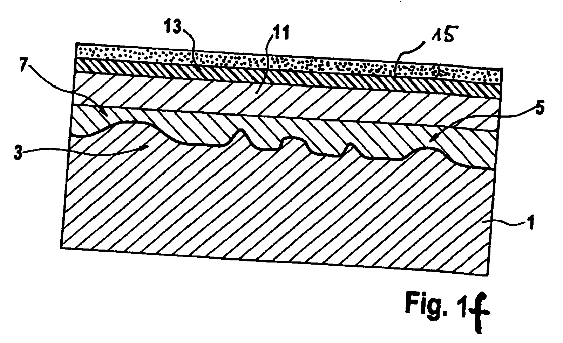

- Figur 1f: das Substrat gemäß Figur 1e mit transparenter Deckschicht.

Im Folgenden wird der Ablauf einer Ausführungsform des erfindungsgemäßen Verfahrens anhand der Beschichtung eines Leichtmetallbauteils erläutert. In Figur 1a ist eine schematische Teilquerschnittsansicht eines metallischen Substrats 1 in Form eines Ausschnitts einer Aluminiumleichtmetallbauteils 2 dargestellt. Die Unebenheiten 3 der Metalloberfläche sind zur besseren Veranschaulichung überzeichnet und schematisch dargestellt. Zunächst kann die Oberfläche des Substrats 1 in zwei Beizschritten entfettet werden. Dies dient dazu, Trennmittelrückstände aus dem Substratfertigungsprozess, die sich auf der Oberfläche des Substrats 1 befinden können, zu entfernen. Insbesondere erfolgen diese beiden Entfettungsschritte derart, dass das Leichtmetallbauteil 2 zunächst in ein, vorzugsweise alkalisches, Beizbad eingetaucht wird. In einem zweiten Beizschritt wird die Leichtmetallfelge 2 in einem etwa 60°C warmen, vorzugsweise alkalischen, Beizbad gebadet. Anschließend wird das Leichtmetallbauteil 2 durch Spülen von den Beizrückständen befreit. Sodann kann die Oberfläche des Leichtmetallbauteils 2 bzw. des Substrats 1 einem Dekapierschritt mit z.B. einem pH-sauren Mittel zur Entfernung einer vorhandenen Oxidationsschicht unterzogen werden. Nach dem Spülen mit Wasser und anschließend vorzugsweise mit vollentsalztem Wasser kann eine erste Grundierungsschicht 5 auf das Substrat 1 aufgebracht werden (s.a. Fig. 1b). Vorzugsweise erfolgt die Aufbringung der Grundierungsschicht in einem Nasslackbeschichtungsverfahren. Nach dem Aufbringen der Grundierung erfolgt vorzugsweise ein Wärmebehandlungs- bzw. Temperschritt, um eine Aushärtung bzw. ein Einbrennen der Grundierungsschicht 5 zu erreichen. Wie insbesondere Figur 1b zu entnehmen ist, entsteht durch die Grundierungsschicht 5 eine im Vergleich zur Oberfläche 3 des Substrats deutlich ebenere Oberfläche 7.

Optional kann auf die Grundierungsschicht 5 zwecks weiterer Oberflächeneinebnung eine weitere, in diesem Ausführungsbeispiel nicht dargestellte, zweite Grundierungsschicht aufgebracht werden. Diese dient insbesondere zur Erzeugung einer optimal glatten Oberfläche, einer optimalen Oberflächenhärte sowie auch dazu, eine nochmals optimierte Oberflächenspannung zu erreichen. Ein derart vorbereitetes Leichtmetallbauteil 2 kann den erfindungsgemäßen Verfahrensschritten zugeführt werden. Selbstverständlich kann auch jedes nicht vorbehandelte metallische Substrat dem erfindungsgemäßen Verfahren unterzogen werden, insbesondere im polierten und/oder geschliffenen Zustand.

Hierfür wird, wie aus Figur 1c ersichtlich, vorzugsweise in einem Kathodenzerstäubungsprozess, eine Metallschicht 9 aus z.B. Aluminium auf dem Substrat 1 bzw. der Grundierungsschicht 5 aufgebracht. Die durchschnittliche Dicke der Metallschicht kann hierbei z.B. etwa 50 bis 120 nm betragen.

In einem nachfolgenden Schritt kann optional eine Wärmebehandlung bzw. ein Tempern der Aluminiumschicht 9 vorgenommen werden, das vorzugsweise bei einer Temperatur von etwa 140°C durchgeführt wird.

Optional kann vorgesehen sein, dass ein Haftvermittler zwischen der Grundierungsschicht 5 und der Aluminiumschicht 9 insbesondere dadurch erzeugt wird, dass eine Plasmavorbehandlung in der Vakuumkammer, die zur Katodenzerstäubung dient, stattfindet. Durch diese Plasmavorbehandlung (Glimmen) in einer Edelgasatmosphäre (vorzugsweise umfassend Argon) kann ein sogenannter "base coat" aufgebracht werden. Eine derartige Erzeugung eines Haftvermittlers (nicht abgebildet) auf der Oberfläche der ersten Grundierungsschicht 5 bietet ebenfalls wirtschaftliche Vorteile, da in dem späteren Kathodenzerstäubungsprozeß der Druck in der Vakuumkammer in der Regel nicht mehr so niedrig gehalten werden muss, wodurch die Abpumpzeit der Vakuumkammer um circa 75% verkürzt werden kann, was wiederum die Durchlaufmengen erhöht. Dazu wird vorzugsweise ein Polymer, wie Hexamethyldisiloxan, in die Plasmakammer während der Erzeugung des Plasmas eingeführt.

Auf das Aufbringen der Aluminiumschicht 9 folgt dann bei der vorliegenden Ausführungsform, insbesondere unmittelbar im Anschluss, die Behandlung mit einem ersten wässrigen System, enthaltend Zirkonsäure (H₂ZrF₆) und/oder Zirkoniumsalze wie Zirkoniumcarbonat, beispielsweise Ammoniumzirkoniumcarbonat, und/oder Zirkoniumoxynitrat und gegebenenfalls Zirkoniumdioxid und/oder Fluorsäure. Das erste wässrige System verfügt vorliegend über einen pH-Wert von etwa 2,5 und einen Leitwert kleiner 100 µS/cm. Die pH-Wert-Einstellung kann mit verdünnter Ammoniaklösung vorgenommen werden.

Bevorzugt wird für die Herstellung des ersten wässrigen Systems auf vollentsalztes Wasser zurückgegriffen. Vorteilhafterweise wird das mit der Aluminiumschicht versehene Substrat über geeignete Düsen mit dem beschriebenen ersten wässrigen System über eine Vielzahl an Hochdruckstrahlen, vorzugsweise mit einem Druck größer 0,5 bar, beaufschlagt. Durch bzw. während dieses Behandlungsprozesses werden die vorangehend beschriebenen Verbindungen des Zirkoniums in die Aluminiumschicht im Wesentlichen über deren gesamte Dicke eingetragen. In dieser Schicht liegt dann Zirkonium bzw. oxydisch gebundenes Zirkonium vor. Anschließend erfolgt vorzugsweise eine Spülung der Oberfläche mit vollentsalztem Wasser. Das erhaltene Substrat wird sodann vorzugsweise einem Trocknungsschritt unterzogen. Wie Figur 1d zu entnehmen ist, wird durch die Anwendung des erfindungsgemäßen Verfahren auf dem Substrat 1 eine metallische Schutz- bzw. Kompositschutzschicht 11 aus einem ersten Metall erhalten, in die ein zweites Metall bzw. ein oxidisch gebundenes zweites Metall, vorzugsweise des Titans oder Zirkoniums eingelagert sind. Diese Einlagerung erfolgt bei dem erfindungsgemäßen Verfahren vorzugsweise nicht nur oberflächennah, sondern erstreckt sich in das Volumen der Kompositschutzschicht 11 hinein.

Die Kompositschutzschicht 11 wird im Anschluss dem Silanisierungsschritt unterworfen, beispielsweise durch Behandlung mit einem alkalischen zweiten wässrigen System, z.B. mit pH 10, enthaltend 3-Aminopropyltriethoxysilan, beispielsweise in einer Menge von etwa 10 Gew.-%. Die Behandlung findet hier nicht als no-rinse-Verfahren statt. Im Anschluss an die Behandlung mit dem genannten zweiten wässrigen System, wird das so erhaltene Substrat mit Wasser, vorzugsweise entsalztem Wasser, z.B. VE-Wasser, gespült. Die Silanisierung schließt dann mit einem Trocknungs- und einem Aushärtschritt unter Ausbildung einer Polysiloxanschicht 13 ab.

Um einer Beschädigung der metallischen Schutzschicht 11 durch mechanische Einflüsse noch stärker entgegenzuwirken, wird abschließend auf diese Polysiloxanschicht 13 eine transparente Decklackschicht 15 aufgebracht. Dabei kann es sich insbesondere um einen Pulverklarlack umfassend Acryl, Polyester oder ein Mischpulver handeln, oder es können auch Nasslacke aufgebracht werden (s.a. Figur 1e).

Die in der vorstehenden Beschreibung, in den Zeichnungen sowie in den Ansprüchen offenbarten Merkmale der Erfindung können sowohl einzeln, als auch in jeder beliebigen Kombination für die Verwirklichung der Erfindung in ihren verschiedenen Ausführungsformen wesentlich sein.

### Bezugszeichenliste

- 1: Substrat
- 2: Leichtmetallfelge
- 3: Oberflächenunebenheiten
- 5: Grundierungsschicht
- 7: Oberfläche
- 9: Aluminiumschicht
- 11: metallische Schutz- bzw. Kompositschutzschicht
- 13: Polysiloxanschicht
- 15: Decklackschicht

## Patentansprüche

1. Verfahren zur Herstellung eines metallischen oder nicht-metallischen metallisch beschichteten Substrats, umfassend die Schritte:
a) Zurverfügungstellung mindestens eines Substrats mit mindestens einer zumindest bereichsweise metallisch beschichtbaren Oberfläche;
c) Aufbringen mindestens einer metallischen Kompositschutzschicht, enthaltend als Hauptkomponente mindestens ein erstes Metall ausgewählt aus der Gruppe, bestehend aus Aluminium, Mangan, Magnesium, Titan und Zink, oder mindestens eine erste Metalllegierung ausgewählt aus der Gruppe, bestehend aus Stahl, Edelstahl, einer Magnesiumlegierung, einer Titanlegierung und einer Aluminiumlegierung, und in der Hauptkomponente verteilt vorliegend als Minderkomponente mindestens ein zweites Metall und/oder mindestens ein oxydisch gebundenes zweites Metall, ausgewählt aus der Gruppe, bestehend aus Zirkonium, Titan und Hafnium, oder bestehend aus der Hauptkomponente und der Minderkomponente, wobei der Verfahrensschritt c) die Teilschritte umfasst
i) Aufbringen mindestens einer Metallschicht enthaltend das oder bestehend aus dem mindestens einen ersten Metall oder enthaltend die oder bestehend aus der mindestens einen ersten Metalllegierung mittels Aufdampf- und/oder Sputter-Technik auf der beschichtbaren Oberfläche des Substrats und
ii) Behandeln der Metallschicht gemäß Schritt i) mit mindestens einem ersten wässrigen System, enthaltend mindestens eine erste Verbindung des zweiten Metalls;
d) Silanisieren der Kompositschutzschicht aus Schritt c) ii) durch Behandeln mit mindestens einem zweiten wässrigen System, enthaltend mindestens eine zu Polykondensations- und/oder Polyadditionsreaktionen befähigte Silanverbindung, unter Ausbildung mindestens einer Polysiloxanschicht auf der Kompositschutzschicht; und
e) Aufbringen mindestens einer Lackschicht auf der Polysiloxanschicht gemäß Schritt d).

2. Verfahren nach Anspruch 1, **dadurch gekennzeichnet, dass** das metallische Substrat Eisen, Magnesium, Titan oder Aluminium, oder Stahl, Edelstahl, Magnesium-, Titan- oder Aluminiumlegierungen, oder dass das nicht-metallische Substrat Glas, Keramik, Carbonmaterialien oder Kunststoff umfasst und/oder dass das erste Metall ausgewählt ist aus der Gruppe, bestehend aus Aluminium, Magnesium und Titan, oder dass die erste Metalllegierung ausgewählt ist aus der Gruppe, bestehend aus Stahl, Edelstahl, mindestens einer Magnesium-, mindestens einer Titan- und mindestens einer Aluminiumlegierung und/oder dass das zweite Metall ausgewählt ist aus der Gruppe, bestehend aus Zirkonium und Titan.

3. Verfahren nach Anspruch 1 oder 2, **dadurch gekennzeichnet, dass** die metallische Kompositschutzschicht oder die Metallschicht eine durchschnittliche Dicke im Bereich von 5 nm bis 500 nm oder im Bereich von 10 nm bis 300 nm oder im Bereich von 20 nm bis 200 nm oder im Bereich von 50 bis 150 nm aufweist.

4. Verfahren nach einem der vorangehenden Ansprüche, **dadurch gekennzeichnet, dass** die erste Verbindung des zweiten Metalls mindestens ein Oxid, Doppeloxid, Oxid-Hydrat, Oxyhalogenid, Halogenid, Salz und/oder eine Säure umfasst.

5. Verfahren nach einem der vorangehenden Ansprüche, **dadurch gekennzeichnet, dass** man die Metallschicht mit dem ersten wässrigen System besprüht oder in sonstiger Weise unter Druck beaufschlagt und/oder dass man nach dem Aufbringen der Metallschicht gemäß Schritt c) i) und vor dem Behandlungsschritt c) ii) das Substrat einem Spülschritt mit Wasser unterzieht

6. Verfahren nach einem der vorangehenden Ansprüche, **dadurch gekennzeichnet, dass** die Aufdampf- bzw. Sputter-Technik in Schritt c) Physical Vapor Deposition (PVD), Aufdampfen mittels eines Elektronenstrahl-Verdampfers, Aufdampfen mittels eines Widerstandsverdampfers, Induktionsverdampfung, ARC-Verdampfung und/oder Kathodenzerstäubung (Sputter-Beschichtung) umfasst.

7. Verfahren nach einem der vorangehenden Ansprüche, **dadurch gekennzeichnet, dass** die zur Polykondensations- und/oder Polyadditionsreaktionen befähigte Silanverbindung des zweiten wässrigen Systems hydrolysierbare und/oder zumindest teilweise hydrolysierte Silane umfasst.

8. Verfahren nach einem der vorangehenden Ansprüche, **dadurch gekennzeichnet, dass** die Silanverbindungen mit Amino-, Acryl-, Vinyl- und/oder mit Epoxygruppen funktionalisierte hydrolysierbare und/oder partiell und/oder vollständig hydrolysierte Alkoxysilane umfassen.

9. Verfahren nach einem der vorangehenden Ansprüche, **dadurch gekennzeichnet, dass** die Silanverbindungen ausgewählt sind aus der Gruppe bestehend aus 3-Glycidoxypropyltri(m)ethoxysilan, 3,4-Epoxybutyltri(m)ethoxysilan, 2-(3,4-Epoxycyclohexyl)ethyltri(m)ethoxysilan, 3-(Meth)acryloxypropyltri(m)ethoxysilan, 2-(Meth)acryloxyethyltri(m)ethoxysilan, 3-Glycidoxypropyldimethyl(m)ethoxysilan, 3-Glycidoxypropylmethyldi(m)ethoxysilan, 3-(Meth)acryloxypropylmethyldi(m)ethoxysilan, 2-(Meth)acryloxyethylmethyl-di(m)ethoxysilan und deren beliebigen Mischungen.

10. Verfahren nach einem der vorangehenden Ansprüche, **dadurch gekennzeichnet, dass** die Silanisierung gemäß Schritt d) nicht als no-rinse-Verfahren durchgeführt und durch Behandlung mit Wasser abgebrochen wird.

11. Verfahren nach einem der vorangehenden Ansprüche, **dadurch gekennzeichnet, dass** bei der Silanisierung Silanverbindungen eingesetzt werden mit funktionellen Gruppen, die beim Silanisierungsschritt nicht oder nicht vollständig abreagieren und die bei der Herstellung der Lackschicht mit den die Lackschicht bildenden Materialien mindestens eine kovalente Bindung eingehen.

12. Verfahren nach einem der vorangehenden Ansprüche, ferner umfassend zwischen den Schritten a) und c) den Schritt:
b) Aufbringen einer ersten Grundierungsschicht oder Aufbringen einer ersten und einer zweiten Grundierungsschicht auf das metallische Substrat und/oder Schleifen und/oder Polieren der metallischen Substratoberfläche.

13. Verfahren nach einem der vorangehenden Ansprüche, **dadurch gekennzeichnet, dass** das erste wässrige System ein saures wässriges System darstellt und/oder dass das zweite wässrige System ein alkalisches wässriges System darstellt.

14. Metallisch beschichtetes Substrat, umfassend, in dieser Reihenfolge,
ein Substrat;
mindestens eine metallische Kompositschutzschicht, enthaltend als Hauptkomponente mindestens ein erstes Metall ausgewählt aus der Gruppe, bestehend aus Aluminium, Mangan, Magnesium, Titan und Zink, oder mindestens eine erste Metalllegierung ausgewählt aus der Gruppe, bestehend aus Stahl, Edelstahl, einer Magnesiumlegierung, einer Titanlegierung und einer Aluminiumlegierung, und in dieser Hauptkomponente verteilt vorliegend als Minderkomponente mindestens ein zweites Metall und/oder mindestens ein oxydisch gebundenes zweites Metall, ausgewählt aus der Gruppe, bestehend aus Zirkonium, Titan und Hafnium, oder bestehend aus der mindestens einen Hauptkomponente und der mindestens einen Minderkomponente, wobei das erste Metall oder die erste Metalllegierung mittels Aufdampf- und/oder Sputter-Technik in Form einer Metallschicht aufgebracht worden ist;
mindestens eine auf der Kompositschutzschicht vorliegende oder an die Kompositschutzschicht zumindest partiell kovalent angebundene, Polysiloxanschicht; mindestens eine auf der Polysiloxansicht vorliegende oder an die Polysiloxanschicht zumindest partiell kovalent angebundene Lackschicht, wobei das zweite Metall und/oder das oxydisch gebundene zweite Metall in der Kompositschutzschicht verteilt vorliegen.

15. Beschichtetes Substrat nach Anspruch 14, **dadurch gekennzeichnet, dass** das metallische Substrat Stahl, Edelstahl, Eisen, Magnesium, Titan oder Aluminium oder Magnesium-, Titan- oder Aluminiumlegierungen, oder dass das nicht-metallische Substrat Glas, Keramik, Carbonmaterialien oder Kunststoff umfasst und/oder dass das erste Metall ausgewählt ist aus der Gruppe, bestehend aus Aluminium, Magnesium und Titan, oder dass die erste Metalllegierung ausgewählt ist aus der Gruppe, bestehend aus Stahl, Edelstahl, mindestens einer Magnesium-, mindestens einer Titan- und mindestens einer Aluminiumlegierung.

16. Beschichtetes Substrat nach einem der Ansprüche 14 oder 15 , **dadurch gekennzeichnet, dass** die metallische Kompositschutzschicht oder die Metallschicht eine durchschnittliche Dicke im Bereich von 5 nm bis 500 nm oder im Bereich von 10 nm bis 300 nm oder im Bereich von 20 nm bis 200 nm oder im Bereich von 50 nm bis 150 nm aufweist.

17. Beschichtetes Substrat nach einem der Ansprüche 14 bis 16, ferner umfassend zwischen dem Substrat und der Metallschicht oder der Kompositschutzschicht eine erste Grundierungsschicht oder eine erste und eine zweite Grundierungsschicht.

18. Beschichtetes Substrat nach einem der Ansprüche 14 bis 17, **dadurch gekennzeichnet, dass** das metallische Substrat Aluminium oder eine Aluminiumlegierung umfasst oder hieraus besteht und dass die metallische Kompositschutzschicht eine Aluminiumschicht als Hauptkomponente umfasst, in der Titan, Zirkonium und/oder Hafnium, und/oder oxydisch gebundenes Titan, Zirkonium und/oder Hafnium als Minderkomponente verteilt vorliegen.

19. Verwendung eines beschichteten Substrats nach einem der Ansprüche 14 bis 18 als Spiegel, verspiegeltes Material oder Reflektor, insbesondere für Scheinwerfer oder Leuchten bzw. Lampen, oder als Bestandteil hiervon; Zubehörteil für den Automobilbau-, Motorradbau- oder Fahrradbaubereich oder als Bestandteil hiervon; Felge, insbesondere Leichtmetallfelge, bzw. Rad, insbesondere Leichtmetallrad, oder als Bestandteil hiervon für den Automobilbaubereich oder für den Motorrad- oder Fahrradbaubereich; Sanitäreinrichtungsgegengstand, insbesondere als Armatur, oder als Bestandteil hiervon; Karosserieinnen- oder außenbauteil oder als Bestandteil hiervon; Griff oder Griffkomponente, insbesondere Türgriff, oder als Bestandteil hiervon; Profil oder Rahmen, insbesondere Fensterrahmen, oder als Bestandteil hiervon; Gehäuse oder als Verpackung oder als Bestandteil hiervon; Innen- oder Außenbauteil von Schiffen oder als Bestandteil hiervon; Schmuckgegenstand oder als Bestandteil hiervon; Möbelbauteil oder als Bestandteil hiervon; Innen- oder Außenbauteil von Flugzeugen oder als Bestandteil hiervon; Innen- oder Außenbauteil von Gebäuden oder als Bestandteil hiervon; Heizkörper oder Rohr oder als Bestandteil hiervon; Bauteil von Aufzügen oder als Bestandteil hiervon; Bauteil von Eletronikkomponenten oder -geräten oder als Bestandteil hiervon; oder als Bauteil von Kommunikationskomponenten oder -geräten, insbesondere Handys, oder als Bestandteil hiervon.

## Claims

1. A method for producing a metallic or non-metallic metal-coated substrate, comprising the following steps:
a) providing at least one substrate with at least one, at least regionally, metal-coatable surface;
c) applying at least one metallic composite protective layer, containing as a main component at least one first metal selected from the group consisting of aluminum, manganese, magnesium, titanium and zinc, or at least one first metal alloy selected from the group consisting of steel, stainless steel, a magnesium alloy, a titanium alloy and an aluminum alloy, and at least one second metal and/or at least one oxidically bonded second metal selected from the group consisting of zirconium, titanium and hafnium distributed as a minor component in the main component, or composed of the main component and the minor component, wherein method step c) comprises the following sub-steps
i) applying at least one metal layer, containing or composed of the at least one first metal or containing or composed of the at least one first metal alloy, to the coatable surface of the substrate by means of vapor deposition and/or sputtering; and
ii) treating the metal layer according to step i) with at least one first aqueous system, containing at least one first compound of the second metal;
d) silanizing the composite protective layer from step c) ii) by treating said composite protective layer with at least one second aqueous system comprising at least one silane compound capable of polycondensation and/or polyaddition reactions, forming at least one polysiloxane layer on the composite protective layer; and
e) applying at least one lacquer layer onto the polysiloxane layer according to step d).

2. The method according to Claim 1, **characterized in that** the metallic substrate comprises iron, magnesium, titanium or aluminum, or steel, stainless steel, magnesium, titanium or aluminum alloys, or that the non-metallic substrate comprises glass, ceramics, carbon materials or plastic, and/or that the first metal is selected from the group consisting of aluminum, magnesium and titanium, or that the first metal alloy is selected from the group consisting of steel, stainless steel, at least one magnesium alloy, at least one titanium alloy and at least one aluminum alloy, and/or that the second metal is selected from the group consisting of zirconium and titanium.

3. The method according to Claim 1 or 2, **characterized in that** the metallic composite protective layer or the metal layer has an average thickness in the range from 5 nm to 500 nm or in the range from 10 nm to 300 nm or in the range from 20 nm to 200 nm or in the range from 50 to 150 nm.

4. The method according to any one of the preceding claims, **characterized in that** the first compound of the second metal comprises at least one oxide, double oxide, oxide hydrate, oxyhalogenide, halogenide, salt and/or an acid.

5. The method according to any one of the preceding claims, **characterized in that** the metal layer is sprayed with the first aqueous system or otherwise treated under pressure, and/or that after applying the metal layer according to step c) i) and prior to the treatment step c) ii) the substrate is subjected to a rinsing step with water.

6. The method according to any one of the preceding claims, **characterized in that** the vapor deposition or sputtering technique in step c) comprises physical vapor deposition (PVD), vapor deposition using an electron beam vaporizer, vapor deposition using a resistance vaporizer, induction vaporization, ARC vaporization and/or cathode spraying (sputter coating).

7. The method according to any one of the preceding claims, **characterized in that** the silane compound of the second aqueous system capable of polycondensation and/or polyaddition reactions comprises hydrolyzable and/or at least partially hydrolyzed silanes.

8. The method according to any one of the preceding claims, **characterized in that** the silane compounds comprise functionalized hydrolyzable and/or partially and/or fully hydrolyzed alkoxysilanes containing amino, acryl, vinyl and/or epoxy groups.

9. The method according to any one of the preceding claims, **characterized in that** the silane compounds are selected from the group consisting of 3-glycidoxypropyl tri(m)ethoxysilane, 3,4-epoxybutyl tri(m)ethoxysilane, 2-(3,4-epoxycyclohexyl)ethyl tri(m)ethoxysilane, 3-(meth)acryloxypropyl tri(m)ethoxysilane, 2-(meth)acryloxyethyl tri(m)ethoxysilane, 3-glycidoxypropyldimethyl(m)ethoxysilane, 3-glycidoxypropylmethyl di(m)ethoxysilane, 3-(meth)acryloxypropylmethyl di(m)ethoxysilane, 2-(meth)acryloxyethylmethyl di(m)ethoxysilane, and any mixtures thereof.

10. The method according to any one of the preceding claims, **characterized in that** the silanization according to step d) is not conducted as a no-rinse method and is aborted by treating with water.

11. The method according to any one of the preceding claims, **characterized in that** silane compounds are used for silanization which have functional groups which do not or do not completely react in the silanization step and enter into at least one covalent bond with the materials which form the lacquer layer during the production of said lacquer layer.

12. The method according to any one of the preceding claims, further comprising between steps a) and c) the step:
b) applying a first base coat layer or applying a first and a second base coat layer to the metallic substrate and/or grinding and/or polishing the metallic substrate surface.

13. The method according to any one of the preceding claims, **characterized in that** the first aqueous system constitutes an acidic aqueous system and/or that the second aqueous system constitutes an alkaline aqueous system.

14. A metal-coated substrate comprising in this order,
a substrate;
at least one metallic composite protective layer, containing as a main component at least one first metal selected from the group consisting of aluminum, manganese, magnesium, titanium and zinc, or at least one first metal alloy selected from the group consisting of steel, stainless steel, a magnesium alloy, a titanium alloy and an aluminum alloy, and at least one second metal and/or at least one oxidically bonded second metal selected from the group consisting of zirconium, titanium and hafnium distributed as a minor component in this main component, or composed of the at least one main component and the at least one minor component, wherein the first metal or the first metal alloy has been applied in the form of a metal layer by means of vapor deposition and/or sputtering; at least one polysiloxane layer present on the composite protective layer or at least partially covalently bonded to the composite protective layer; at least one lacquer layer present on the polysiloxane layer or at least partially covalently bonded to the polysiloxane layer, wherein the second metal and/or the oxidically bonded second metal is distributed in the composite protective layer.

15. The coated substrate according to Claim 14, **characterized in that** the metallic substrate comprises steel, stainless steel, iron, magnesium, titanium or aluminum, or magnesium, titanium or aluminum alloys, or that the non-metallic substrate comprises glass, ceramics, carbon materials or plastic, and/or that the first metal is selected from the group consisting of aluminum, magnesium and titanium, or that the first metal alloy is selected from the group consisting of steel, stainless steel, at least one magnesium alloy, at least one titanium alloy and at least one aluminum alloy.

16. The coated substrate according to any one of Claims 14 or 15, **characterized in that** the metallic composite protective layer or the metal layer has an average thickness in the range from 5 nm to 500 nm or in the range from 10 nm to 300 nm or in the range from 20 nm to 200 nm or in the range from 50 to 150 nm.

17. The coated substrate according to any one of Claims 14 to 16, further comprising between the substrate and the metal layer or the composite protective layer a first base coat layer or a first and a second base coat layer.

18. The coated substrate according to any one of Claims 14 to 17, **characterized in that** the metallic substrate comprises aluminum or an aluminum alloy or consists thereof, and that the metallic composite protective layer comprises an aluminum layer as a main component in which titanium, zirconium and/or hafnium, and/or oxidically bonded titanium, zirconium and/or hafnium, is/are distributed as a minor component.

19. Use of a coated substrate according to any one of Claims 14 to 18 as a mirror, mirrored material or reflector, in particular for headlights or lights and/or lamps, or as a component hereof; an automobile, motorbike or bicycle accessory or as a component hereof; a wheel rim, in particular a light metal wheel rim, and/or wheel, in particular a light metal wheel, or as a component hereof for automobiles, motorbikes or bicycles, a sanitary facility object, in particular as a faucet, or as a component hereof; an interior or exterior car body part or as a component hereof; a handle or handle component, in particular a door handle, or as a component hereof; a profile or frame, in particular a window frame, or as a component hereof; a housing or packaging or as a component hereof; an interior or exterior construction element of a ship or as a component hereof; a jewelry object or as a component hereof; a furniture piece or as a component hereof; an interior or exterior construction element of an airplane or as a component hereof; an interior or exterior construction element of a building or as a component hereof; a radiator or pipe or as a component hereof; a construction element in an elevator or as a component hereof; a construction element in an electronic component or device or as a component hereof; or a construction element in a communication component or device, in particular a cell phone, or as a component hereof.

## Revendications

1. Procédé pour la fabrication d'un substrat métallique ou non métallique à revêtement métallique, comprenant les étapes de :
a) mise à disposition d'au moins un substrat avec au moins une surface sur laquelle un revêtement métallique est applicable au moins par zones ;
c) application d'au moins une couche de protection composite métallique, comprenant comme composant principal au moins un premier métal sélectionné parmi le groupe se composant de l'aluminium, du manganèse, du magnésium, du titane et du zinc, ou au moins un premier alliage métallique sélectionné parmi le groupe se composant de l'acier, de l'acier spécial, d'un alliage de magnésium, d'un alliage de titane et d'un alliage d'aluminium, et, présent dans le composant principal comme composant secondaire y étant distribué, au moins un deuxième métal et/ou au moins un deuxième métal lié par oxydes, sélectionné parmi le groupe se composant du zircon, du titane et de l'hafnium, ou se composant du composant principal et du composant secondaire, l'étape de procédé c) comprenant les étapes partielles de
i) application sur la surface du substrat pouvant être revêtue d'au moins une couche métallique comprenant le, ou se composant d'au moins un premier métal, ou comprenant le, ou se composant d'au moins un premier alliage métallique au moyen d'une technique de dépôt en phase vapeur et/ou de pulvérisation, et
ii) traitement de la couche métallique conformément à l'étape i) avec au moins un premier système aqueux comprenant au moins un premier composé du deuxième métal ;
d) silanisation de la couche de protection composite de l'étape c) ii) par traitement d'au moins un deuxième système aqueux, comprenant au moins un composé de silane rendu capable de réactions de polycondensation et/ou de polyaddition, par formation d'au moins une couche de polysiloxane sur la couche de protection composite ; et
e) application d'au moins une couche de peinture sur 1a couche de polysiloxane conformément à l'étape d).

2. Procédé selon la revendication 1, **caractérisé en ce que** le substrat métallique comprend du fer, du magnésium, du titane ou de l'aluminium, ou de l'acier, de l'acier spécial, des alliages de magnésium, de titane ou d'aluminium, ou **en ce que** le substrat non métallique comprend du verre, de la céramique, des matériaux en carbone ou des matières plastiques et/ou **en ce que** le premier métal est sélectionné parmi le groupe se composant de l'aluminium, du magnésium et du titane, ou **en ce que** le premier alliage métallique est sélectionné parmi le groupe se composant de l'acier, de l'acier spécial, d'au moins un alliage de magnésium, d'au moins un alliage de titane et d'au moins un alliage d'aluminium et/ou **en ce que** le deuxième métal est sélectionné parmi le groupe se composant du zircon et du titane.

3. Procédé selon 1a revendication 1 ou 2, **caractérisé en ce que** la couche de protection composite métallique ou la couche métallique présente une épaisseur moyenne dans la plage de 5 nm à 500 nm ou dans 1a plage de 10 nm à 300 nm ou dans la plage de 20 nm à 200 nm ou dans la plage de 50 nm à 150 nm.

4. Procédé selon l'une des revendications précédentes **caractérisé en ce que** le premier composé du deuxième métal comprend au moins un oxyde, un oxyde double, un hydrate d'oxyde, un oxyhalogénure, un halogénure, un sel et/ou un acide.

5. Procédé selon l'une des revendications précédentes **caractérisé en ce que** l'on pulvérise le premier système aqueux sur la couche métallique ou qu'on applique à celle-ci une pression d'une quelconque autre manière et/ou **en ce qu'**on soumet le substrat à une étape de rinçage à l'eau après l'application de la couche métallique conformément à l'étape c) i) et avant l'étape de traitement c) ii).

6. Procédé selon l'une des revendications précédentes **caractérisé en ce que** la technique de dépôt en phase vapeur ou de pulvérisation de l'étape c) comprend le dépôt physique en phase vapeur (PVD), le dépôt par EBPVD, le dépôt par évaporateur thermique, l'évaporation par induction, l'évaporation par arc et/ou la pulvérisation cathodique (revêtement par pulvérisation).

7. Procédé selon l'une des revendications précédentes **caractérisé en ce que** le composé de silane rendu capable de réactions de polycondensation et/ou de polyaddition du deuxième système aqueux comprend des silanes hydrolysables et/ou au moins partiellement hydrolisés.

8. Procédé selon l'une des revendications précédentes **caractérisé en ce que** les composés de silane comprennent des alkoxysilanes hydrolisables et/ou partiellement et/ou entièrement hydrolisés fonctionnalisés avec des groupes amine, acryle, vinyle et/ou époxy.

9. Procédé selon l'une des revendications précédentes **caractérisé en ce que** les composés de silane sont sélectionnés parmi le groupe se composant de 3-glycidoxyprapyltri(m)éthoxysilane, 3,4-époxybutyltri(m)éthoxysilane, 2-(3,4-époxycyclohexyl)éthyltri(m)éthoxysilane, 3-(méth)acryloxypropyltri(m)éthoxysilane, 2-(méth)acryloxyéthyltri(m)éthoxysilane, 3-glycidoxypropyldiméthyl(m)éthoxysilane, 3-glycidoxypropylméthyldi(m)éthoxysilane, 3-(méth)acryloxypropylméthyldi(m)éthoxysilane, 2-(méth)acryloxyéthylméthyl-di(m)éthoxysilane et de leurs mélanges quelconques.

10. Procédé selon l'une des revendications précédentes **caractérisé en ce que** la silanisation conforme à l'étape d) n'est pas effectuée comme procédé « sans rinçage » et est interrompue par un traitement à l'eau.

11. Procédé selon l'une des revendications précédentes **caractérisé en ce que**, lors de la silanisation, des composés de silane sont employés avec des groupes fonctionnels qui ne réagissent pas ou pas complètement lors de la silanisation et qui forment au moins une liaison covalente avec les matériaux formant la couche de peinture lors de l'application de la couche de peinture.

12. Procédé selon l'une des revendications précédentes comprenant de plus, entre les étapes a) et c), l'étape de :
b) application d'une première couche primaire ou application d'une première et d'une deuxième couche primaire sur le substrat métallique et/ou ponçage et/ou polissage de la surface du substrat métallique.

13. Procédé selon l'une des revendications précédentes **caractérisé en ce que** le premier système aqueux représente un système aqueux acide et/ou **en ce que** le deuxième système aqueux représente un système aqueux alcalin.

14. Substrat à revêtement métallique, comprenant, dans cet ordre,
un substrat ;
au moins une couche de protection composite métallique, comprenant comme composant principal au moins un premier métal sélectionné parmi le groupe se composant de l'aluminium, du manganèse, du magnésium, du titane et du zinc, ou au moins un premier alliage métallique sélectionné parmi le groupe se composant de l'acier, de l'acier spécial, d'un alliage de magnésium, d'un alliage de titane et d'un alliage d'aluminium, et, présent dans ce composant principal comme composant secondaire y étant distribué, au moins un deuxième métal et/ou au moins un deuxième métal lié par oxydes, sélectionné parmi le groupe se composant du zircon, du titane et de l'hafnium, ou se composant de l'au moins un composant principal et de l'au moins un composant secondaire, le premier métal ou le premier alliage métallique ayant été appliqué sous la forme d'une couche métallique au moyen d'une technique de dépôt en phase vapeur et/ou de pulvérisation;
au moins une couche de polysiloxane présente sur la couche de protection composite ou liée de façon covalente à la couche de protection composite au moins partiellement ; au moins une couche de peinture présente sur la couche de polysiloxane ou liée de façon covalente à la couche de polysiloxane au moins partiellement, le deuxième métal et/ou le deuxième métal lié par oxydes étant distribué dans la couche de protection composite.

15. Substrat revêtu selon la revendication 14, **caractérisé en ce que** le substrat métallique comprend de l'acier, de l'acier spécial, du fer, du magnésium, du titane ou de l'aluminium, ou des alliages de magnésium, de titane ou d'aluminium, ou **en ce que** le substrat non métallique comprend du verre, de la céramique, des matériaux en carbone ou des matières plastiques et/ou **en ce que** le premier métal est sélectionné parmi le groupe se composant de l'aluminium, du magnésium et du titane, ou **en ce que** le premier alliage métallique est sélectionné parmi le groupe se composant de l'acier, de l'acier spécial, d'au moins un alliage de magnésium, d'au moins un alliage de titane et d'au moins un alliage d'aluminium.

16. Procédé selon les revendications 14 ou 15, **caractérisé en ce que** la couche de protection composite métallique ou la couche métallique présente une épaisseur moyenne dans la plage de 5 nm à 500 nm ou dans la plage de 10 nm à 300 nm ou dans la plage de 20 nm à 200 nm ou dans la plage de 50 nm à 150 nm.

17. Substrat revêtu selon l'une des revendications 14 à 16, comprenant de plus une première couche primaire, ou une première et une deuxième couches primaires, entre le substrat et la couche métallique ou la couche de protection composite.

18. Substrat revêtu selon l'une des revendications 14 à 17, **caractérisé en ce que** le substrat métallique comprend de l'aluminium ou un alliage d'aluminium ou en est composé et **en ce que** la couche de protection composite métallique comprend une couche d'aluminium comme composant principal, dans laquelle sont distribués comme composants secondaires du titane, du zircon et/ou de l'hafnium et/ou du titane, du zircon et/ou de l'hafnium liés par oxydes.

19. Utilisation d'un substrat revêtu selon l'une des revendications 14 à 18 comme miroir, matériau réfléchissant ou réflecteur, en particulier pour projecteurs ou pour feux ou lampes, ou partie de ceux-ci ; pièce accessoire pour le secteur de la construction de voitures, de motos ou de vélos, ou partie de celle-ci ; jante, en particulier jante en métal léger, ou roue, en particulier roue en métal léger, ou partie de celle-ci pour le secteur de la construction de voitures, de motos ou de vélos ; objet d'installation sanitaire, en particulier comme robinetterie ou partie de celle-ci ; pièce intérieure ou extérieure de carrosserie ou partie de celle-ci ; poignée ou composant de poignée, en particulier poignée de porte ou partie de celle-ci ; profil ou cadre, en particulier châssis de fenêtres, ou partie de ceux-ci ; boîtier ou emballage, ou partie de ceux-ci ; pièce intérieure ou extérieure de bateaux ou partie de celle-ci ; bijou, ou partie de celui-ci ; élément de mobilier, ou partie de celui-ci ; pièce intérieure ou extérieure d'avions, ou partie de celle-ci ; pièce intérieure ou extérieure de bâtiments, ou partie de celle-ci ; pièce intérieure ou extérieure de radiateur ou de tuyau, ou partie de celle-ci ; pièce d'ascenseurs, ou partie de celle-ci ; pièce de composants ou d'appareils électroniques, ou partie de celle-ci ; ou comme pièce de composants ou d'appareils de communication, en particulier de téléphones portables, ou partie de celle-ci.
